# EUROPÄISCHE PATENTANMELDUNG

(11) **EP 3 868 915 A1**
(43) Veröffentlichungstag der Anmeldung: **25.08.2021**
(21) Anmeldenummer: 21157701.0
(22) Anmeldetag: 17.02.2021
(51) Int. Cl.: C23C 14/04, C23C 14/34, C23C 14/00, C23C 14/56, C23C 14/50, C23C 14/35

(54) **VERFAHREN ZUM BESCHICHTEN MITTELS DAMPFPHASENABSCHEIDUNG**

(30) Priorität: 17.02.2020 DE 102020104113
(71) Anmelder: BENSELER Beschichtungen Bayern GmbH & Co. KG, 94327 Bogen (DE)
(72) Erfinder: GEIßLER, Bernhard, 90592 Schwarzenbruck (DE)
(74) Vertreter: Louis Pöhlau Lohrentz

(57) **Zusammenfassung**

Die Erfindung betrifft ein Verfahren zum Beschichten wenigstens einer Oberfläche mittels Dampfphasenabscheidung in wenigstens einer Beschichtungskammer, die wenigstens eine Verdampferquelle zum Verdampfen von wenigstens einem Verdampfungsmaterial enthält, wobei wenigstens ein erstes Beschichtungsmaterial in wenigstens einem ersten Teilbereich der Oberfläche mit wenigstens einer ersten Schichtdicke und in wenigstens einem zweiten Teilbereich der Oberfläche mit wenigstens einer zweiten Schichtdicke, wobei die wenigstens eine erste und die wenigstens eine zweite Schichtdicke voneinander verschieden sind, mittels Dampfabscheidung abgeschieden wird,
oder
wenigstens in einem ersten Teilbereich der Oberfläche wenigstens ein erstes Beschichtungsmaterial und wenigstens in einem zweiten Teilbereich der Oberfläche wenigstens ein zweites Beschichtungsmaterial, das verschieden von dem wenigstens einen ersten Beschichtungsmaterial ist, mittels Dampfabscheidung abgeschieden wird,
wobei in wenigstens einer Beschichtungskammer zwischen wenigsten einer Verdampferquelle und wenigstens einem Teilbereich der Oberfläche wenigstens ein Abschirmelement zum Abschirmen dieses Teilbereichs während der Dampfphasenabscheidung vorgesehen wird.

## Beschreibung

Die Erfindung betrifft ein Verfahren zum Beschichten wenigstens einer Oberfläche mittels Dampfphasenabscheidung in wenigstens einer Beschichtungskammer, die wenigstens eine Verdampferquelle zum Verdampfen von wenigstens einem Verdampfungsmaterial.

Verfahren zum Beschichten einer Oberfläche mittels Dampfphasenabscheidung werden allgemein in physikalische Dampfphasenabscheidungsverfahren und in chemische Dampfphasenabscheidungsverfahren unterteilt. Die Verfahren zur physikalischen Dampfphasenabscheidung werden auch als PVD-Verfahren (PVD: Physical Vapour Deposition) bezeichnet. Die chemischen Dampfphasenabscheidungsverfahren werden auch CVD-Verfahren (CVD: Chemical Vapour Deposition) bezeichnet. Bei einem PVD-Verfahren kondensiert ein in die Gasphase überführtes Ausgangsmaterial auf einer Oberfläche unter Ausbildung einer Beschichtung. Bei einem CVD-Verfahren kommt es an der zu beschichtenden Oberfläche zu einer chemischen Umsetzung.

Mit Dampfphasenabscheidungsverfahren können homogene Schichten, insbesondere Dünnschichten, mit definierter Schichtdicke auf einer Oberfläche mit einer Schichtdicke im Nanometer- bis Mikrometerbereich aufgebracht werden. Über die Schichtenfolge und Schichtendicke können die optischen Eigenschaften im Hinblick auf das Reflexions- und/oder Transmissionsverhalten wellenlängenabhängig eingestellt werden.

Die DE 198 44 021 A1 offenbart ein Verkleidungsteil aus Kunststoff, auf dessen Oberfläche eine dünne Metallschicht aufgedampft ist. Das Verkleidungsteil dient der Verkleidung eines hinter einem Frontgrill eines Kraftfahrzeuges angebrachten Radar-Abstandmessungsgeräts. Bei der dünnen Metallschicht handelt es sich um eine etwa 40 nm dicke Metallschicht aus Indium. Durch diese dünne Metallschicht aus Indium werden die Radarstrahlen des Radar-Abstandsmessgerätes gesendet und empfangen. Gemäß der Lehre der DE 19844021 A1 soll der flüchtige Betrachter des Frontgrills die Existenz des eingesetzten Verkleidungsteiles nicht erkennen.

Die DE 198 19 709 A1 offenbart ein Verfahren zur Herstellung eines Radoms für ein Abstandswarnradar, wobei Embleme oder charakteristische Strukturen integriert werden. Hierzu wird ein Folienmaterial in eine gewünschte strukturbildende Form gebracht und mit einer metallischen Schicht versehen. Die metallische Schicht soll dabei im sichtbaren Wellenlängenbereich elektromagnetische Strahlung vollständig reflektieren und die längerwelligen Radarwellen nahezu ungeschwächt hindurchtreten lassen.

Die DE 100 26 454 C1 offenbart ein Radom für ein Abstand-Warn-Radar, das eine dünne Metallschicht aufweist. Gemäß der Lehre der DE 10026454 C1 kann die Metallschicht unter Anlegung eines Stromes beheizt werden, so dass die Bildung von Schnee- oder Eisschichten verhindert wird.

Die DE 10 2005 032 717 B3 offenbart eine Bedieneinheit mit einer metallischen Beschichtung, die lichtdurchlässige und lichtundurchlässige Bereiche mit einem unterschiedlichen optischen Erscheinungsbild aufweisen.

Die 10 2011 016 683 A1 offenbart ein radartransparentes Bauteil, bei dem zumindest Teile der Oberfläche eine zumindest ein Halbleitermaterial umfassende Schicht aufweist, deren Dicke zwischen 10 nm und 100 nm liegt.

Die DE 100 28 801 A1 offenbart ein Radom für einen Radarsensor aus einem radartransparenten Material, das zumindest in Teilbereichen eine Beschichtung aufweist, wobei die Beschichtung zumindest in Teilbereichen strukturiert ist.

Die DE 101 23 344 B4 offenbart ein Verfahren zur Herstellung eines Zierteils für den Innenraum von Fahrzeugen, wobei auf einem Trägerteil eine metallische Schicht zunächst mittels PVD-Verfahren aufgebracht und sodann die metallische Schicht zumindest in einem Teilbereich der Oberfläche des Zierteils mittels eines Lasers entfernt wird.

Die bislang bekannten durch PVD-Verfahren hergestellten Beschichtungen weisen ein homogenes Erscheinungsbild auf. Sofern, wie in der DE 101 23 344 B4 beschrieben, in Zierteilen Teilbereiche nicht metallisiert sein sollen, ist eine aufwendige Entfernung der abgeschiedenen PVD-Beschichtung mittels Laserbearbeitung erforderlich.

Eine Aufgabe der vorliegenden Erfindung ist es, ein verbessertes Verfahren zum Beschichten einer Oberfläche bereitzustellen, wobei der Oberfläche in verschiedenen Bereichen unterschiedliche optische und/oder dekorative Eigenschaften verliehen werden.

Eine weitere Aufgabe der Erfindung ist es, ein Verfahren zur Herstellung von definiert inhomogenen Beschichtungen bereitzustellen.

Eine weitere Aufgabe der Erfindung ist es, ein Verfahren zur Herstellung von dekorativen Beschichtungen und/oder Beschichtungen mit verbesserten funktionalen optischen Eigenschaften bereitzustellen.

Die der Erfindung zugrundeliegende Aufgabe wird durch Bereitstellung eines Verfahrens zum Beschichten wenigstens einer Oberfläche mittels Dampfphasenabscheidung in wenigstens einer Beschichtungskammer, die wenigstens eine Verdampferquelle zum Verdampfen von wenigstens einem Verdampfungsmaterial enthält, gelöst, wobei wenigstens ein erstes Beschichtungsmaterial in wenigstens einem ersten Teilbereich der Oberfläche mit wenigstens einer ersten Schichtdicke und in wenigstens einem zweiten Teilbereich der Oberfläche mit wenigstens einer zweiten Schichtdicke, wobei die wenigstens eine erste und die wenigstens eine zweite Schichtdicke voneinander verschieden und vorzugsweise die Schichtdicken jeweils konstant sind, mittels Dampfabscheidung abgeschieden wird,
oder
wenigstens in einem ersten Teilbereich der Oberfläche wenigstens ein erstes Beschichtungsmaterial und wenigstens in einem zweiten Teilbereich der Oberfläche wenigstens ein zweites Beschichtungsmaterial, das verschieden von dem wenigstens einen ersten Beschichtungsmaterial ist, mittels Dampfabscheidung abgeschieden wird, wobei vorzugsweise der wenigstens eine erste Teilbereich und der wenigstens eine zweite Teilbereich jeweils homogen ist,
wobei in wenigstens einer Beschichtungskammer zwischen wenigsten einer Verdampferquelle und wenigstens einem Teilbereich der Oberfläche wenigstens ein Abschirmelement zum Abschirmen dieses Teilbereichs während der Dampfphasenabscheidung vorgesehen wird.

Bevorzugte Weiterbildungen des Verfahrens sind in den Ansprüchen 2 bis 18 angegeben.

Die Aufgabe der Erfindung wird auch durch Bereitstellung einer beschichteten Oberfläche, erhältlich nach einem Verfahren gemäß einem der Ansprüche 1 bis 18 gelöst. Die Aufgabe der Erfindung wird auch durch Verwendung einer beschichteten Oberfläche nach Anspruch 19 zu dekorativen Zwecken und/oder funktionalen optischen Zwecken gelöst.

Das erfindungsgemäße Verfahren kann dabei als PVD-Verfahren (PVD: Physical Vapour Deposition) oder als CVD-Verfahren (Chemical Vapour Deposition) ausgestaltet sein. Gemäß einer bevorzugten Variante der Erfindung handelt es sich bei dem erfindungsgemäßen Verfahren um ein PVD-Verfahren.

Das Verdampfungsmaterial wird dabei in einer Verdampferquelle angeordnet. Die Verdampferquelle kann auch als Target bezeichnet werden. Die Verdampferquelle kann dabei als Kathode ausgebildet sein.

Das Verdampfen kann sodann durch thermisches Verdampfen, Elektronenstrahlverdampfen, Laserstrahlverdampfen, Lichtbogenverdampfen, Sputtern, ionenstrahlgestütztes Abscheiden, lonenplattieren, ICB-Verfahren (lonized Clustered Beam Deposition) bewirkt werden.

Gemäß einer bevorzugten Variante der Erfindung werden die abzuscheidenden Atome mittels Sputtern, das auch als Kathodenzerstäubung bezeichnet wird, aus einer Verdampferquelle, d.h. einem Festkörper, dem sogenannten Target, durch Beschuss mit energiereichen Ionen, vorzugsweise Edelgasionen, herausgelöst und in die Gasphase überführt.

Das erfindungsgemäße Dampfphasenabscheidungsverfahren, vorzugsweise PVD-Verfahren wird dabei vorzugsweise in einer Unterdruckumgebung durchgeführt. Der Arbeitsdruck kann dabei in einem Bereich von 10⁻¹ mbar bis 10⁻⁶ mbar, weiter vorzugsweise von 10⁻³ mbar bis 10⁻⁴ mbar, liegen.

Mittels PVD-Verfahren können Schichten mit definierten Dicken auf eine Oberfläche, beispielsweise Substratoberfläche, aufgebracht werden. Die mittels Dampfphasenabscheidung erzeugten Schichtdicken können dabei von wenigen Nanometern bis zu mehreren Mikrometern variiert werden. So kann beispielsweise das Beschichtungsmaterial auf einer Oberfläche in einer Schichtdicke von 3 nm bis 20 µm, weiter vorzugsweise von 10 nm bis 10 µm, weiter bevorzugt von 20 nm bis 1 µm, aufgebracht werden.

In Abhängigkeit von den gewünschten optischen Eigenschaften kann die Schichtdicke beispielsweise in einem Bereich von 3 nm bis 500 nm, weitervorzugsweise von 10 nm bis 300 nm, weiter vorzugsweise von 15 nm bis 200 nm, weiter bevorzugt von 25 nm bis 150 nm, weiter bevorzugt von 30 nm bis 90 nm, weiter bevorzugt von 35 nm bis 70 nm, liegen.

Bei dem erfindungsgemäßen Verfahren können die Schichtdickenunterschiede zwischen den verschiedenen Schichtdicken sehr genau eingestellt werden. Beispielsweise können die Unterschiede zwischen verschiedenen Schichtdicken der mittels Dampfphasenabscheidung abgeschiedenen Schichten in einem Bereich von 3 bis 10 nm, vorzugsweise von 4 bis 9 nm, weiter vorzugsweise von 5 bis 8 nm, weiter vorzugsweise von 6 bis 7 nm, liegen. Diese hohe Genauigkeit bei der Schichtdicke erlaubt vorteilhaftweise eine genaue Einstellung von Farben für einen Betrachter.

Sofern es sich bei dem Verdampfungsmaterial zugleich um das Beschichtungsmaterial handelt, mithin das Verdampfungsmaterial in der Unterdruckumgebung chemisch nicht verändert wird, dann sind das Verdampfungsmaterial und das Beschichtungsmaterial identisch.

Wenn es sich bei dem Verdampfungsmaterial bzw. Target um ein reines Metall oder eine Metalllegierung handelt, und in der Unterdruckumgebung der PVD-Vorrichtung ausschließlich inertes Gas, beispielsweise Argon, enthalten ist, dann wird auf der zu beschichtenden wenigstens einen Oberfläche reines Metall bzw. eine Metalllegierung abgeschieden. Gemäß einer bevorzugten Variante der Erfindung wird reines Metall verdampft und reines Metall auf der wenigstens einen zu beschichtenden Oberfläche abgeschieden.

Bei dem erfindungsgemäßen Verfahren ist zwischen der wenigstens einen Verdampferquelle und der zu beschichtenden wenigstens einen Oberfläche ein Abschirmelement so angeordnet, dass wenigstens ein Teilbereich der zu beschichtenden Oberfläche im Hinblick auf die Verdampferquelle abgeschirmt wird. Die Größe und/oder Geometrie und/oder räumlichen Anordnung in der Beschichtungskammer des Abschirmelementes kann dabei geeignet gewählt werden.

Bei dem erfindungsgemäßen Verfahren können auch wenigstens zwei Verdampferquellen in wenigstens einer Beschichtungskammer vorgesehen sein. Die wenigstens zwei Verdampferquellen können dabei einander zugewandt, vorzugsweise einander gegenüberliegend, angeordnet sein. Die wenigstens eine zu beschichtende Oberfläche kann bei einer Ausführungsform des erfindungsgemäßen Verfahrens zwischen den beiden Verdampferquellen angeordnet sein. Diese Ausführungsform erlaubt ein zeitgleiches oder ein zeitlich versetztes Abscheiden, beispielsweise auf die Vorderseite und/oder die Rückseite der wenigstens einen zu beschichtenden Oberfläche. Bei dieser Ausführungsform ist ein Beschichten mit identischen oder voneinander verschiedenen Beschichtungsmaterialien möglich. Gemäß einer bevorzugten Variante der Erfindung erfolgt, vorzugsweise zeitgleich, ein Beschichten mit wenigstens zwei Beschichtungsmaterialien, die voneinander verschieden sind.

Des Weiteren kann bei einer Anordnung von zwei Verdampferquellen, vorzugsweise Kathoden, die Beschichtungszeit bei Verwendung eines Drehelements signifikant verkürzt werden.

Das Abschirmelement kann eine rechteckige, beispielsweise quadratische, runde, beispielsweise kreisrunde oder ovale, polygonale Form, beispielsweise in Form eines Dreiecks, Vierecks, beispielsweise einer Raute, Fünfecks, Sechsecks, Siebenecks oder Achtecks, aufweisen. Es können auch Abschirmelemente mit verschiedenen Geometrien in einer Beschichtungskammer angeordnet werden. Das Abschirmelement kann auch in Form einer Käfigstruktur oder Zaunstruktur, beispielsweise mit stäbchenförmigen Anordnungen, ausgebildet sein.

Das in der wenigstens einen Verdampferquelle enthaltene Verdampfungsmaterial wird verdampft, vorzugsweise durch Sputtern verdampft. Das verdampfte Material bewegt sich beispielsweise ballistisch oder geführt durch elektrische Felder durch die Beschichtungskammer auf die zu beschichtende Oberfläche.

Bei Anordnung wenigstens eines Abschirmelementes zwischen der Verdampferquelle und der zu beschichtenden Oberfläche wird der durch das Abschirmelement abgeschirmte Teilbereich der zu beschichtenden Oberfläche in Abhängigkeit von der Größe und/oder Geometrie und/oder räumlichen Anordnung in der Beschichtungskammer in einem geringeren Umfang beschichtet oder wird nicht beschichtet.

Bei Anordnung eines oder mehrerer Abschirmelemente zwischen Verdampferquelle und zu beschichtender Oberfläche ist es mithin möglich, auf die zu beschichtende Oberfläche definierte inhomogene Schichten abzuscheiden.

Unter definiert inhomogenen Schichten werden im Sinne der Erfindung mittels Dampfphasenabscheidung aufgebrachte Beschichtungen verstanden, die in verschiedenen Teilbereichen der Beschichtung beispielsweise definiert voneinander verschiedene Schichtdicken, definiert voneinander verschiedene Beschichtungsmaterialien, definiert voneinander verschiedene Schichtfolgen, etc., aufweisen. Die verschiedenen Teilbereiche können für sich jeweils eine homogene Beschichtung aufweisen, die jedoch bezogen auf die gesamte Oberfläche voneinander verschiedenen sind. Erfindungsgemäß ist es bevorzugt, dass die in verschiedenen Teilbereichen jeweils abgeschiedenen Schichten in sich homogen sind, beispielsweise im Hinblick auf die Schichtdicke und/oder die Zusammensetzung des Beschichtungsmaterials in dem jeweiligen Teilbereich. Die definiert inhomogenen Schichten weisen für einen Betrachter beispielsweise als dekorativen Effekt einen wahrnehmbaren Farbverlauf auf. Auch können die über das erfindungsgemäße Verfahren hergestellten Beschichtungen für einen Betrachter einheitlich wahrnehmbar sein, jedoch in verschiedenen Teilbereichen verschiedene optische Eigenschaften aufweisen, beispielsweise im Hinblick auf eine wellenlängenabhängige Transmission.

Unter einer homogenen Beschichtung wird im Sinne der Erfindung verstanden, dass eine beschichtete Oberfläche über den gesamten Oberflächenbereich eine einheitliche Schichtdicke und/oder einheitliche dekorative und/oder funktionale optische Eigenschaften aufweist.

Beispielsweise können bei Anordnung von zwei Verdampferquellen und einem Abschirmelement in der Beschichtungskammer auf der zu beschichtenden Oberfläche Beschichtungen aufgebracht werden, bei denen Teilbereiche unterschiedliche Dicken aufweisen, je nachdem ob der Teilbereich der Oberfläche nicht durch das Abschirmelement abgeschirmt wird oder ob der Teilbereich im Kernschatten oder Halbschatten , der durch die beiden Verdampferquellen und das eine Abschirmelement hervorgerufen wird, angeordnet ist.

Liegt der Teilbereich der Oberfläche im Kernschatten, dann gelangt weder aus der ersten noch aus der zweiten Verdampferquelle verdampftes Material auf den im Kernschatten liegenden Oberflächenteilbereich. Folgt die Abschirmung der wenigstens einen Oberfläche lediglich im Hinblick auf die eine Verdampferquelle, jedoch nicht im Hinblick auf die auf die zweite Verdampferquelle, dann liegt der zu beschichtende Oberflächenteilbereich in einem Halbschatten und wird in einem geringeren Umfang bedampft, als dies in einem Bereich der Fall ist, bei dem das verdampfte Material sowohl aus der ersten Verdampferquelle als auch aus der zweiten Verdampferquelle auf den zu beschichtende Oberflächenteilbereich gelangt.

Mithin können durch das erfindungsgemäße Verfahren in Abhängigkeit von der Anzahl und Anordnung der Verdampferquellen sowie der Anordnung und Anzahl von Abschirmelementen auf einer zu beschichtenden Oberfläche Teilbereiche erzeugt werden, in denen die Schichtdicken voneinander verschieden sind.

Gemäß einer Variante des erfindungsgemäßen Verfahrens kann das Beschichtungsmaterial in wenigstens einem ersten Teilbereich von dem wenigstens einen zweiten Teilbereich voneinander verschieden abgeschieden werden. In diesem ersten Teilbereich, zweiten Teilbereich und gegebenenfalls weiter vorhandenen dritten, vierten, fünften etc. Teilbereichen können jeweils für sich Schichtdicken aufgebracht werden, die voneinander verschieden sein können.

Die Schichtdicke in den verschiedenen Teilbereichen wird dabei so eingestellt, dass ein gewünschter dekorativer und/oder funktionaler optischer Effekt eingestellt wird.

Beispielsweise kann über die Einstellung der Schichtdicke(n) der abgeschiedenen Schicht(en) und Teilschicht(en) die Absorption und/oder Reflexion und/oder Transmission, vorzugsweise der Reflexion und/oder Transmission, von eingestrahltem Licht beeinflusst werden.

An Dünnschichtfilmen kommt es, bedingt durch Reflexion und/oder Transmission, zu Interferenzeffekten, die bei einem Betrachter einen Farbeindruck hervorrufen, mithin beispielsweise Gold, Rot, Grün, Blau, etc.. Durch geeignete Einstellung der Schichtdicke(en) und/oder der flächig übereinander angeordneten Schichten können im Wesentlichen sämtliche Farben im gesamten Farbraum, beispielsweise im L*a*b-Farbraum, erzeugt werden.

Somit können in Abhängigkeit von der Anzahl an übereinander angeordneten Schichten und Teilschichten sowie deren Dicken ein gewünschter Farbeindruck, beispielsweise mit einem dekorativen und/oder funktionalen Effekt, für einen Betrachter gezielt eingestellt werden.

Gemäß einer weiteren Variante des erfindungsgemäßen Verfahrens wird wenigstens in einem ersten Teilbereich wenigstens ein erstes Beschichtungsmaterial und wenigstens in einem zweiten Teilbereich wenigstens ein zweites Beschichtungsmaterial, das verschieden von dem wenigstens einen ersten Beschichtungsmaterials ist, mittels Dampfabscheidung abgeschieden.

Bei dieser Ausführungsform kann eine Beschichtungsvorrichtung in einer ersten Beschichtungskammer wenigstens eine erste Verdampferquelle mit einem ersten Verdampfungsmaterial und in einer zweiten Beschichtungskammer wenigstens eine zweite Verdampferquelle mit einem zweiten Verdampfungsmaterial vorgesehen sein. In der Beschichtungsvorrichtung können auch eine Mehrzahl an Beschichtungskammern, beispielsweise zwei, drei, vier, fünf oder mehr Beschichtungskammern vorgesehen sein, wobei in jeder Beschichtungskammer als Verdampfungsmaterial ein Verdampfungsmaterial vorgesehen sein kann, das von dem des Verdampfungsmaterial in der jeweils vorangegangenen Beschichtungskammer verschieden sein kann.

In Abhängigkeit von der Größe und/oder Geometrie und/oder Anordnung des Abschirmelementes in der wenigstens einen Beschichtungskammer können mithin Teilbereiche auf wenigstens einer Oberfläche erzeugt werden, bei denen sich das abgeschiedene erste Beschichtungsmaterial und das abgeschiedene zweite Beschichtungsmaterial voneinander unterscheiden.

Des Weiteren kann die Schichtdicke des wenigstens einen ersten Beschichtungsmaterials in wenigstens einem ersten Teilbereich und die Schichtdicke des wenigstens einen zweiten Beschichtungsmaterials in wenigstens einem zweiten Teilbereich gleich oder voneinander verschieden sein. Gemäß einer Variante der Erfindung ist die Schichtdicke des wenigstens einen ersten Beschichtungsmaterials in einem ersten Teilbereich und die Schichtdicke des wenigstens einen zweiten Beschichtungsmaterials in einem zweiten Teilbereich voneinander verschieden. Gemäß einer weiteren Variante ist die Schichtdicke des wenigstens einen ersten Beschichtungsmaterials in einem ersten Teilbereich und die Schichtdicke des wenigstens einen zweiten Beschichtungsmaterials in einem zweiten Teilbereich gleich.

Gemäß einer weiteren Variante kann das erfindungsgemäße Verfahren wiederholt durchgeführt werden, wobei zwischen dem wenigstens einen ersten Verfahrensdurchgang und dem wenigstens einen zweiten Verfahrensdurchgang das Verdampfungsmaterial in der Verdampfungsquelle ausgetauscht wird.

Des Weiteren ist es gemäß einer weiteren Variante des erfindungsgemäßen Verfahrens möglich, zusätzlich auch die Größe und/oder Geometrie und/oder räumliche Anordnung des Abschirmelementes zu ändern. Selbstverständlich kann auch dann, wenn das Verdampfungsmaterial in der Verdampferquelle ausgetauscht wird, zusätzlich auch die Größe und/oder Geometrie und/oder Anordnung des Abschirmelementes geändert werden.

Selbstverständlich ist es auch möglich, nach einem Austausch des Verdampfungsmaterials in der Verdampferquelle die räumliche Anordnung der zu beschichtenden Oberfläche in der Beschichtungskammer zu ändern.

Gemäß einer weiteren Variante des erfindungsgemäßen Verfahrens wird die wenigstens eine Oberfläche, d.h. die zu beschichtende Oberfläche, und die wenigstens eine Verdampferquelle während der Dampfphasenabscheidung relativ zueinander bewegt.

Vorzugsweise wird die wenigstens eine Oberfläche, d.h. die zu beschichtende Oberfläche, relativ zu der wenigstens einen Verdampferquelle während der Dampfphasenabscheidung rotiert oder bewegt, vorzugsweise rotiert.

Gemäß einer weiteren Variante des erfindungsgemäßen Verfahrens ist die wenigstens eine Oberfläche ortsfest zu der wenigstens einen Verdampferquelle während der Dampfphasenabscheidung angeordnet.

Um die zu beschichtende wenigstens eine Oberfläche vollständig oder in einem Teilbereich homogen, insbesondere mit einer über die jeweilige Fläche definierten konstanten Schichtdicke, zu beschichten, ist es bevorzugt, dass die wenigstens eine Oberfläche relativ zu der wenigstens einen Verdampferquelle während der Dampfphasenabscheidung rotiert oder bewegt, vorzugsweise rotiert, wird.

Gemäß einer weiteren bevorzugten Ausführungsform wird die wenigstens eine Oberfläche während der Dampfphasenabscheidung an oder auf einem Drehelement, vorzugsweise einem Drehzylinder, angeordnet. Das Drehelement, vorzugsweise der Drehzylinder, wird vorzugsweise um seine Längsachse rotiert, so dass die auf der Drehzylinderoberfläche angeordnete zu beschichtende Oberfläche, vorzugsweise mit konstanter Winkelgeschwindigkeit, gegenüber der wenigstens einen Verdampferquelle exponiert wird. Das Drehelement kann auch pyramidal, kegelförmig, stumpfkegelförmig, wendeiförmig etc. ausgebildet sein.

Bei der wenigstens einen Oberfläche kann es sich um die Oberfläche einer vorzugsweise transparenten, weiter vorzugsweise im sichtbaren Wellenlängenbereich und/oder für IR-Strahlung transparenten, Folie oder eines, vorzugsweise transparenten, weiter vorzugsweise im sichtbaren Wellenlängenbereich und/oder für IR-Strahlung transparenten, plattenförmigen Materials, handeln. Eine solche Folie oder Platte kann auf der Oberfläche eines Drehelements angeordnet werden. Bei der bevorzugten Verwendung eines Drehzylinders als Drehelement liegt eine solche Folie oder Platte vorzugsweise flächig auf der Zylinderoberfläche an. Bei der Platte handelt es sich vorzugsweise um biegsames Material, vorzugsweise aus Kunststoff.

Bei der wenigstens einen Oberfläche kann es sich auch um einen dreidimensionalen Formkörper aus oder mit Kunststoff, Keramik, Glas, Metall, Mischungen oder Kombinationen davon handeln.

Bei einem Formkörper aus oder mit Metall kann es sich beispielsweise um Metalldruckgusskörper, beispielsweise einen Zinkdruckgusskörper oder Aluminiumdruckgusskörper handeln.

Bei der wenigstens einen Oberfläche kann es sich auch um die Oberfläche einer metallisierten Folie oder Platte oder um eine Metallfolie oder Metallplatte handeln.

Die Metallfolie kann beispielsweise aus der Gruppe, die aus Aluminiumfolie, Kupferfolie, Eisenfolie, Stahlfolie und Kombinationen davon besteht, ausgewählt werden.

Die Metallplatte kann beispielsweise aus der Gruppe, die aus Aluminiumplatte, Aluminiumblech, Kupferplatte, Kupferblech, Eisenplatte, Eisenblech, Stahlplatte, Stahlblech und Kombinationen davon besteht, ausgewählt werden.

Bei einer Drehung des Drehelements, vorzugsweise eines Drehzylinders, bevorzugt mit einer konstanten Winkelgeschwindigkeit, wird auf der Oberfläche der Folie oder der Platte das Beschichtungsmaterial unter Ausbildung einer homogenen Schicht mit definierter Schichtdicke in einem definierten Bereich oder Teilbereich abgeschieden. Durch Anordnung wenigstens eines Abschirmelementes, das auch als Blende bezeichnet werden kann, in der Beschichtungskammer zwischen zu beschichtender Oberfläche und Verdampferquelle wird die wenigstens eine Oberfläche in der Abhängigkeit von der Geometrie und/oder Größe und/oder räumlicher Anordnung des Abschirmelementes in verschiedenen Teilbereichen unterschiedlich beschichtet. So kann in einem ersten Teilbereich beispielsweise die Schichtdicke 10 %, 20 %, 30 %, 40 %, 50 %, 60 %, 70 %, 80 %, 90 % oder 100 % dicker sein als in einem zweiten Teilbereich der beschichteten Oberfläche.

Das erfindungsgemäße Verfahren kann auch wiederholt in einer oder mehreren Beschichtungskammer(n) durchgeführt werden. So ist es beispielsweise möglich, nach einem ersten Beschichtungsvorgang die Größe und/oder Geometrie und/oder räumliche Anordnung des Abschirmelementes zu verändern. Bei dieser Variante wird mithin beispielsweise bei einer Veränderung der räumlichen Anordnung und/oder Größe und/oder Geometrie des Abschirmelementes auf der zu beschichtenden Oberfläche ein von dem ersten Durchgang verschiedener Teilbereich abgeschirmt. Mithin können in verschiedenen Durchgängen verschiedene Teilbereiche abgeschirmt bzw. beschichtet werden. Beispielsweise ist es möglich, dass die in einem ersten und zweiten oder weiterem Verfahrensdurchgang entsprechend abgeschiedenen Beschichtungen in Teilbereichen einander überlappen oder aneinander angrenzen oder voneinander beabstandet sind.

Bei einer weiteren Variante des erfindungsgemäßen Verfahrens kann auch die räumliche Anordnung des Abschirmelementes in der Beschichtungskammer aus dem ersten Verfahrensdurchgang beibehalten werden und beispielsweise die räumliche Anordnung der wenigstens einen zu beschichtenden Oberfläche in der Beschichtungskammer geändert werden. Beispielsweise könnte, bei Verwendung eines Drehelementes, beispielsweise eines Drehzylinders, das Drehelement um 180° gedreht in der Beschichtungskammer angeordnet werden. In diesem Fall wird beispielsweise der bereits beschichtete Teilbereich der Oberfläche von dem Abschirmelement gegenüber der Verdampferquelle zumindest teilweise abgeschirmt und der bislang nicht beschichtete Bereich gegenüber der Verdampferquelle exponiert.

Bei einer Wiederholung des erfindungsgemäßen Verfahrens, beispielsweise zweimal, dreimal, viermal oder fünfmal oder mehr können mithin Teilbereiche der zu beschichtenden Oberfläche mit voneinander verschiedener Schichtdicke versehen werden. Wie vorstehend ausgeführt kann das eine Abschirmelement oder können die mehreren Abschirmelement bei der Wiederholung des Verfahrens räumlich auch so angeordnet werden, dass Teilbereiche der abgeschiedenen Beschichtung aneinandergrenzen oder teilweise oder vollständig einander überlappen.

Die mit einer abgeschiedenen Beschichtung versehene Oberfläche weist im einfachsten Fall zwei Teilbereiche auf. Selbstverständlich kann die mit einer abgeschiedenen Beschichtung versehene Oberfläche auch drei beschichtete Teilbereiche, vier beschichtete Teilbereiche, fünf beschichtete Teilbereiche oder mehr beschichtete Teilbereiche aufweisen.

Die Unterteilung der zu beschichtenden Oberfläche in verschiedene Teilbereiche kann, wie vorstehend ausgeführt, über die räumliche Anordnung der zu beschichtenden Oberfläche in der Beschichtungskammer und/oder die räumliche Anordnung und/oder Größe und/oder Geometrie des Abschirmelementes oder der Abschirmelemente in der Beschichtungskammer eingestellt werden.

Gemäß einer weiteren bevorzugten Ausführungsform des erfindungsgemäßen Verfahrens werden das wenigstens eine Beschichtungsmaterial in wenigstens einem ersten Teilbereich der Oberfläche und in wenigstens einem zweiten Teilbereich der Oberfläche in einer gemeinsamen Schichtebene mit voneinander verschiedenen Schichtdicken mittels Dampfphasenabscheidung abgeschieden.

Unter einer gemeinsamen Schichtebene wird im Sinne der Erfindung verstanden, dass die beschichteten Teilbereiche nach der Dampfphasenabscheidung nebeneinander, beispielsweise aneinandergrenzend oder voneinander beabstandet, in einer Schichtebene auf der wenigstens einen Oberfläche angeordnet sind. Gemäß einer weiteren Variante können zwischen einem wenigstens ersten beschichteten Teilbereich und einem wenigstens zweiten beschichteten Teilbereich auch ein beschichteter Zwischenbereich vorgesehen sein.

Der wenigstens eine erste beschichtete Teilbereich und der wenigstens eine zweite beschichtete Teilbereich können sich beispielsweise in der Schichtdicke voneinander unterscheiden. In dem zwischen diesen beiden beschichteten Teilbereichen etwaig angeordneten beschichtete(n) Zwischenbereiche(n) kann die Schichtdicke von dem ersten beschichteten Teilbereich sich zur Schichtdicke des zweiten beschichtete Teilbereichs ändern. Beispielsweise kann in einem ersten beschichteten Teilbereich die Schichtdicke des Beschichtungsmaterials beispielsweise 20 nm betragen und in einem zweiten beschichteten Teilbereich beispielsweise 40 nm. In einem beschichteten Zwischenbereich kann sodann eine Änderung von 20 nm auf 40 nm gegeben sein.

Sofern beispielsweise in einem ersten Teilbereich der Oberfläche ein erstes Beschichtungsmaterial abgeschieden ist und in einem zweiten Teilbereich der Oberfläche ein von dem ersten Beschichtungsmaterial verschiedenes zweites Beschichtungsmaterial abgeschieden ist, können diese beiden beschichteten Teilbereiche unmittelbar aneinander angrenzen oder mittelbar über einen Zwischenbereich oder voneinander beabstandet sein. In einem beschichteten Zwischenbereich können sodann sowohl das erste Beschichtungsmaterial als auch das zweite Beschichtungsmaterial gemeinsam vorhanden sein.

Der etwaige beschichtete Zwischenbereich zwischen einem ersten, vorzugsweise in sich homogenen, beschichteten Teilbereich und einem zweiten, vorzugsweise in sich homogenen, beschichteten Teilbereich kann eng oder breit ausgestaltet sein.

Sofern die abgeschiedene Beschichtung beispielsweise dekorativen Zwecken dient, kann der beschichtete Zwischenbereich beispielsweise als kontinuierliche Farbänderung von einer ersten Farbe eines ersten Teilbereichs zu einer zweiten Farbe eines zweiten Teilbereichs der Oberfläche ausgestaltet sein. Beispielsweise kann mithin ein Farbverlauf von reinem Rot, über Rot-Grün nach Grün-Rot zu einem reinen Grün gestaltet werden. Selbstverständlich können auch andere Farbverläufe, beispielsweise von Blau nach Grün oder von Hellgold bis Braungold über Violett bis zu einem tiefen Blau und bis zu einem türkisen Farbeindruck erzeugt werden. Erfindungsgemäß kann im Wesentlichen der gesamte Farbraum, vorzugsweise im L*a*b-Farbraum, beispielsweise über die Schichtdicke und/oder die Anzahl der Schichten und/oder das jeweils verwendete Beschichtungsmaterial, dargestellt werden.

Mithin erlaubt das erfindungsgemäße Verfahren unter Verwendung von einem oder mehreren Abschirmelement(en) die Erzeugung eines Farbverlaufs von einer ersten zu einer zweiten Farbe oder von einer ersten Farbe über eine zweite Farbe zu einer dritten Farbe. Auch ist es selbstverständlich möglich, Farbverläufe über vier, fünf oder sechs verschiedene Farben zu erzeugen.

Gemäß einer weiteren Ausführungsform der Erfindung wird das wenigstens eine Abschirmelement zwischen wenigstens einer Verdampferquelle und dem abgeschirmten Teilbereich in wenigstens einer Beschichtungskammer ortsfest oder beweglich, vorzugsweise ortsfest, angeordnet. Bei einer ortsfesten Anordnung ist das Abschirmelement zwischen der Verdampferquelle und der zu beschichtenden Oberfläche ortsfest, d.h. stationär in der wenigstens einen Beschichtungskammer angeordnet. Das wenigstens eine Abschirmelement kann aber auch ortsfest in Bezug auf die zu beschichtende Oberfläche angeordnet sein. Bei dieser Variante ist das wenigstens eine Abschirmelement nicht ortsfest in einer Beschichtungskammer angeordnet, sondern relativ zu der zu beschichtenden Oberfläche, beispielsweise an der zu beschichtenden Oberfläche. Somit können die zu beschichtende Oberfläche und das wenigstens eine Abschirmelement relativ zueinander fixiert sein, aber beispielsweise auf einer Transporteinheit mobil sein.

Gemäß einer weiteren Ausführungsform der Erfindung ist das wenigstens eine Abschirmelement zwischen wenigstens einer Verdampferquelle und dem abgeschirmten Teilbereich in wenigstens einer Beschichtungskammer beweglich angeordnet. Beispielsweise kann das Abschirmelement rotierbar angeordnet sein. Bei dieser Ausführungsform kann das Abschirmelement um die zu beschichtende Oberfläche drehbar angeordnet sein. Der durch das drehbare Abschirmelement abgeschirmte Teilbereich wird mithin nur temporär, beispielsweise periodisch, abgeschirmt, wenn sich das Abschirmelement zwischen der Verdampferquelle und der zu beschichtenden Oberfläche befindet. Sofern das Abschirmelement nicht mehr zwischen der Verdampferquelle und der zu beschichtenden Oberfläche, sondern sich seitlich oder hinter der zu beschichtenden Oberfläche befindet, dann wird bei dieser räumlichen Anordnung des Abschirmelementes die Gesamtfläche der zu beschichtenden Oberfläche bedampft.

Die Drehgeschwindigkeit kann bei dieser Variante so eingestellt werden, dass die Beschichtungsdicke des nicht abgeschirmten Teilbereichs der Oberfläche und die Schichtdicke des nur temporär, beispielsweise periodisch, abgeschirmten Teilbereichs der Oberfläche in einem definierten Verhältnis steht. Beispielsweise kann das Verhältnis des nicht abgeschirmten Teilbereichs zu dem aufgrund der Drehbewegung des Abschirmelementes temporär, beispielsweise periodisch, abgeschirmten Teilbereichs der Oberfläche in einem Verhältnis von beispielsweise 10:1, 9:1, 8:1, 7:1, 6:1, 5:1, 4:1, 3:1, 2:1, 1,5:1 oder 1,2:1 betragen.

Das wenigstens eine Abschirmelement kann mithin drehbar angeordnet sein, so dass es vorzugsweise um die wenigstens eine zu beschichtende Oberfläche rotiert.

Gemäß einer weiteren Variante der Erfindung kann das Abschirmelement auch beweglich, vorzugsweise linear beweglich sein, so dass es von einer ersten Position in eine zweite Position linear verschiebbar ist. Dabei kann das wenigstens eine Abschirmelement vertikal und/oder horizontal linear verschiebbar sein.

Gemäß einer weiteren Ausführungsform der Erfindung kann das Abschirmelement sowohl beweglich, vorzugsweise linear beweglich, als auch drehbar sein.

Gemäß einer Variante der Erfindung ist das Abschirmelement linear, vorzugsweise vertikal und/oder horizontal, verschiebbar, so dass die räumliche Anordnung oder Position des wenigstens einen Abschirmelementes wenigstens einer Beschichtungskammer zwischen einem ersten Verfahrensdurchgang und einem zweiten Verfahrensdurchgang geändert werden kann. Mithin ist es auf diese einfache Weise möglich, Teilbereiche einer zu beschichtenden Oberfläche mit unterschiedlichen Schichtdicken und/oder unterschiedlichen Beschichtungsmaterialien zu beschichten.

Gemäß einer weiteren Ausführungsform der Erfindung weist das wenigstens eine Abschirmelement Öffnungen auf, wobei die Öffnungen in dem wenigstens einem Abschirmelement symmetrisch oder asymmetrisch verteilt angeordnet sein können.

Die Öffnungen können dabei kreisrund, rechteckig, beispielsweise quadratisch, ausgebildet sein. Die Öffnungen können eine rechteckige Form, beispielsweise quadratische Form, runde Form, beispielsweise kreisrunde oder ovale Form, polygonale Form, beispielsweise in Form eines Dreiecks, Vierecks, beispielsweise in Rautenform, Fünfecks, Sechsecks, Siebenecks oder Achtecks, aufweisen. Es können auch Abschirmelemente, bei denen die Öffnungen verschiedene Geometrien aufweisen, in einer Beschichtungskammer angeordnet werden. Auch innerhalb eines einzelnen Abschirmelementes können die Öffnungen Geometrien aufweisen, die verschieden voneinander sind.

Selbstverständlich ist es auch möglich, die Öffnungen in dem Abschirmelement schlitzartig auszubilden.

Gemäß einer Variante des erfindungsgemäßen Verfahrens kann das Abschirmelement vor der Verdampferquelle, d.h. dem Target oder der Kathode, angeordnet werden. Vorzugsweise ist dabei das Abschirmelement beabstandet von der Verdampferquelle angeordnet, so dass das Verdampfungsmaterial verdampft werden kann, beispielsweise durch Sputtern.

Gemäß einer Variante des erfindungsgemäßen Verfahrens kann das Abschirmelement vor der wenigstens einen zu beschichtenden Oberfläche angeordnet sein. Das Abschirmelement kann dabei unmittelbar vor der zu beschichtenden Oberfläche oder auch beabstandet von bzw. vor der zu beschichtenden Oberfläche angeordnet werden. Je näher das wenigstens Abschirmelement an der zu beschichtenden Oberfläche angeordnet wird, desto geringer fällt der Übergangsbereich zwischen abgeschirmtem Teilbereich und nichtabgeschirmtem Teilbereich der beschichteten Oberfläche aus. Sofern beispielsweise das Abschirmelement Öffnungen aufweist, durch die Beschichtungsmaterial auf die Oberfläche abgeschieden wird, ist das Anordnungsmuster der Öffnungen auf der beschichteten Oberfläche für einen Betrachter um so leichter zu erkennen, je näher das Abschirmelement an bzw. auf der zu beschichtenden Oberfläche angeordnet wird. Je weiter weg das beispielsweise mit Öffnungen versehene Abschirmelement vor der zu beschichtenden Oberfläche angeordnet wird, desto weniger wird das Öffnungsmuster auf der beschichteten Oberfläche abgebildet. Mithin werden im letzteren Fall die Übergänge zwischen abgeschirmten Teilbereich und nicht abgeschirmten Teilbereich nach Abscheidung der Beschichtung "weicher", d.h. der Gradient wird flacher.

Je nachdem, ob das Abschirmelement ortsfest oder beweglich, beispielsweise drehbar angeordnet ist, können auf der wenigstens einen zu beschichtenden Oberfläche Teilbereiche ausgebildet werden, in denen sich die Schichtdicke der mittels Dampfphasenabscheidung aufgebrachten Beschichtung und/oder die Beschichtungsmaterialien voneinander verschieden sind.

Beispielsweise kann bei einer symmetrischen Anordnung von Öffnungen in dem Abschirmelement auf die zu beschichtende Oberfläche eine sich periodisch wiederholenden Beschichtungsstruktur aufgebracht werden. Sofern in dem Abschirmelement beispielsweise periodisch sich wiederholende, vorzugsweise kreisrunde, Öffnungen angeordnet sind, kann auf der wenigstens einen zu beschichtenden Oberfläche eine Beschichtung abgeschieden werden, bei der die Schichtdicke sich periodisch und kontinuierlich über die Fläche ändern. Mithin kann beispielsweise eine Berg- und Talanordnung eines Beschichtungsmateriales, beispielsweise Metall, auf der zu beschichtenden Oberfläche angeordnet sein. Auch können streifenartigen oder gitterartige Beschichtungsstrukturen auf der Oberfläche ausgebildet werden, wobei vorzugsweise die streifenartigen oder gitterartigen Teilbereiche in sich jeweils im Hinblick auf die Schichtdicke und/oder Zusammensetzung homogen sind.

Vorzugsweise erscheint die abgeschiedene Beschichtungsschicht bei einer Ausführungsform der Erfindung für das Auge eines Betrachters insgesamt im Wesentlichen homogen. Die voneinander verschiedenen, jedoch in sich vorzugsweise homogenen Teilbereiche, sind im beispielsweise im Hinblick auf funktionale optische Eigenschaften, insbesondere im Hinblick auf die Transmission von definierten Wellenlängenbereichen, beispielsweise Radarwellen und/oder nahes Infrarot, voneinander verschieden.

Sofern beispielsweise das Abschirmelement mit Schlitzöffnungen versehen ist, ist es bei ortsfester Anordnung des Abschirmelementes möglich, eine streifenartige Struktur auf der zu beschichtenden Oberfläche aufzubringen.

Bei dieser Ausgestaltung der erfindungsgemäßen Verfahrens können streifenartige Teilbereiche erhalten werden, die in sich jeweils homogen sind, beispielsweise jeweils ein definierte Schichtdicke aufweisen, die im Hinblick auf die unterschiedliche Schichtdicke definiert verschiedene Transmissionen, vorzugsweise im Radarwellenbereich oder im nahen IR-Bereich aufweisen. Für das Auge eines Betrachters sind die streifenförmigen Teilbereiche im Wesentlichen nicht zu erkennen. Mithin kann ein Betrachter die streifenförmige Struktur als einheitlich oder homogen wahrnehmen, obgleich die funktionalen optischen Eigenschaften in den Streifen mit höherer und niedrigerer Schichtdicke voneinander verschieden sind, mithin eine definierte funktionale Inhomogenität vorliegt.

Sofern das mit Schlitzen versehene Abschirmelement rotierend um die beschichtende Oberfläche herum angeordnet ist, kann, aufgrund der Drehbewegung, auf den temporär, beispielweise periodisch, abgeschirmten Teilbereich der Oberfläche das Beschichtungsmaterial mit einer geringeren Schichtdicke abgeschieden werden als auf dem nicht abgeschirmten Teilbereich der Oberfläche. So ist es mit einem rotierenden Abschirmelement, das beispielsweise schlitzartige Öffnungen aufweist, möglich, auf den temporär, vorzugsweise periodisch, abgeschirmten Teilbereich der zu beschichtenden Oberfläche eine von dem nicht abgeschirmten Teilbereich der Oberfläche Beschichtungsmaterial mit einer definiert verschiedenen Schichtdicke abzuscheiden.

Gemäß einer weiteren Ausgestaltung des erfindungsgemäßen Verfahrens werden auf die wenigstens eine Oberfläche mittels Dampfphasenabscheidung mehrere flächig übereinanderliegende Schichten abgeschieden, wobei wenigstens eine Schicht der mehreren Schichten wenigstens nur in einem Teilbereich der Oberfläche abgeschieden wird.

Mithin ist es bei dem erfindungsgemäßen Verfahren möglich, die abgeschiedenen Schichten übereinander anzuordnen, wobei wenigstens eine Schicht der mehreren Schichten nur in einem Teilbereich der Oberfläche abgeschieden wird.

Auf diese Weise ist es möglich, die optischen und/oder dekorativen Eigenschaften der beschichteten Oberfläche definiert einzustellen.

So ist es beispielsweise möglich, unter Verwendung eines Abschirmelementes nur einen Teilbereich der zu beschichtenden Oberfläche mittels Dampfphasenabscheidung zu beschichten. Auf diesen beschichteten Teilbereich der Oberfläche kann sodann eine weitere Schicht auf der gesamten Oberfläche mittels Dampfphasenabscheidung aufgebracht werden. Optional können auch noch weitere Schichten in Teilbereich oder auf der gesamten Oberfläche mittels Dampfphasenabscheidung abgeschieden werden.

Gemäß einer weiteren Variante der Erfindung kann eine zu beschichtende Oberfläche zunächst auf der gesamten Oberfläche mittels Dampfphasenabscheidung beschichtet werden.

Auf diese erste vollständige Schicht kann sodann nur ein Teilbereich beschichtet werden, in dem der nicht zu beschichtende Teilbereich mit einem Abschirmelement während einer Dampfphasenabscheidung abgeschirmt wird.

Gemäß einer weiteren Ausgestaltung des erfindungsgemäßen Verfahrens wird die wenigstens eine Oberfläche unter Verwendung einer Transportvorrichtung durch mehrere Beschichtungskammern transportiert, wobei in wenigstens einer Beschichtungskammer zwischen wenigstens einer Verdampferquelle und wenigstens einem Teilbereich wenigstens ein Abschirmelement zum Abschirmen dieses Teilbereichs während der Dampfphasenabscheidung vorgesehen wird und wobei in jeder weiteren Beschichtungskammer zwischen der wenigstens einen Verdampferquelle und dem wenigstens einem Teilbereich wenigstens ein Abschirmelement zum Abschirmen dieses Teilbereichs während der Dampfphasenabscheidung vorgesehen sein können.

Bei dieser Variante der Erfindung sind mehrere Beschichtungskammern nacheinander angeordnet. Vorzugsweise sind die mehreren Beschichtungskammern in einer Beschichtungsvorrichtung angeordnet. Die Beschichtungskammern können mittels entfernbarer Trennelemente, beispielsweise Schiebern, miteinander verbindbar sein.

So kann beispielsweise in einer ersten Beschichtungskammer eine erste Beschichtung, in einer zweiten Beschichtungskammer eine zweite Beschichtung, in einer dritten Beschichtungskammer eine dritte Beschichtung, etc., durchgeführt werden.

In wenigstens einer Beschichtungskammer ist zwischen wenigstens einer Verdampferquelle und wenigstens einem Teilbereich der zu beschichtenden Oberfläche wenigstens ein Abschirmelement zum Abschirmen dieses Teilbereichs während der Dampfphasenabscheidung vorgesehen. In den weiteren Beschichtungskammern können jeweils wenigstens ein Abschirmelement vorgesehen sein oder nicht. Es ist auch möglich, beispielsweise in der ersten Beschichtungskammer ein Abschirmelement vorzusehen, in der zweiten Beschichtungskammer kein Abschirmelement und in der dritten Beschichtungskammer oder jeder weiteren Beschichtungskammer wiederum ein Abschirmelement.

Selbstverständlich ist es auch möglich, in der ersten Beschichtungskammer kein Abschirmelement vorzusehen, jedoch beispielsweise in der zweiten oder dritten oder jeder weiteren Beschichtungskammer.

Erfindungswesentlich ist, dass bei dem Verfahren wenigstens in einer Beschichtungskammer der mehreren Beschichtungskammern wenigstens ein Abschirmelement zum Abschirmen wenigstens eines Teilbereichs der zu beschichtenden Oberfläche vorgesehen wird.

Bei Verwendung mehrerer Beschichtungskammern können in jeder Beschichtungskammer in der Verdampferquelle ein identisches Verdampfungsmaterial oder auch jeweils auch ein verschiedenes Verdampfungsmaterial vorgesehen sein. Es ist auch möglich, beispielsweise in einer ersten Verdampferquelle und in einer dritten Verdampferquelle ein identisches Verdampfungsmaterial vorzusehen, wobei beispielsweise in der zweiten Verdampferquelle und gegebenenfalls in einer vierten Verdampferquelle Verdampfungsmaterialien verwendet werden, die von dem ersten und dritten Verdampfungsmaterial jeweils verschieden sind.

Des Weiteren kann in einer Anordnung von mehreren Beschichtungskammern nacheinander auch in jeder Beschichtungskammer ein Abschirmelement vorgesehen sein, das je nach Beschichtungskammer ortsfest und/oder beweglich und/oder rotierend angeordnet sein kann. So ist es möglich, dass die Abschirmelemente im Hinblick auf die Größe und/oder Geometrie und/oder räumlichen Anordnung in den verschiedenen Beschichtungskammern voneinander verschieden ausgestaltet werden.

Die mehreren Beschichtungskammern sind vorzugsweise so miteinander verbunden, dass die zu beschichtende Oberfläche unter Verwendung einer Transportvorrichtung, beispielsweise eines Transportschlittens oder Transportwagens von einer Beschichtungskammer zur nächsten Beschichtungskammer transportiert werden kann.

Der Transport von einer Beschichtungskammer zur nächsten Beschichtungskammer kann dabei in einer getakteten Weise, beispielsweise in Zeitintervallen, erfolgen, so dass die auf einer Transportvorrichtung, beispielsweise einem Transportschlitten oder einen Transportwagen, angeordnete wenigstens eine Oberfläche in jeder Beschichtungskammer für einen definierten Zeitraum mittels Dampfabscheidung beschichtet wird.

Auf der Transportvorrichtung kann wenigstens eine Oberfläche beispielsweise auf einem Drehelement, beispielsweise einem Drehzylinder, angeordnet sein. Mithin kann somit in jeder Beschichtungskammer eine Beschichtung mittels Dampfabscheidung auf eine sich rotierende Oberfläche aufgebracht werden.

Die mehreren Beschichtungskammern können dabei so zusammengefasst sein, dass an den verschiedenen Beschichtungskammern ein einheitlicher Druck, beispielsweise Unterdruck angelegt ist, wobei die verschiedenen Beschichtungskammern mittels Trennelementen, beispielsweise Schiebern, voneinander separiert sind.

Gemäß einer weiteren Variante des erfindungsgemäßen Verfahrens, ist die wenigstens eine zu beschichtende Oberfläche die Oberfläche einer Folie oder Platte oder die wenigstens eine Oberfläche ist die Oberfläche eines dreidimensionalen Gegenstands, vorzugsweise aus oder mit Kunststoff, Keramik, Metall, und/oder Glas.

Eine erfindungsgemäß zu verwendende Metallfolie oder Metallplatte kann eine Schichtdicke im Bereich von 5 µm bis 1 mm aufweisen.

Der Gegenstand aus oder mit Metall kann ein Formkörper aus Metall, beispielsweise aus Metalldruckguss, wie beispielsweise aus Zinkdruckguss oder Aluminiumdruckguss, sein.

Gemäß einer weiteren Ausführungsform der Erfindung weist die Folie oder Platte Kunststoff auf oder besteht daraus und wird in einem weiteren Schritt dreidimensional verformt, vorzugsweise warmverformt, und optional mit Kunststoff hinterspritzt.

Gemäß einer weiteren Ausführungsform der Erfindung weist die Folie oder Platte Metall auf oder besteht daraus und wird in einem weiteren Schritt dreidimensional verformt, vorzugsweise tiefgezogen wird, und optional mit Kunststoff, Keramik, und/oder Glas hinterspritzt.

Die wenigstens eine Oberfläche kann die Oberfläche einer Folie oder Platte sein. Die Folie kann unter Verwendung des erfindungsgemäßen Verfahrens für dekorative und/oder funktionale, beispielsweise optische, Zwecke bereitgestellt werden. Eine gemäß dem erfindungsgemäßen Verfahren hergestellte Folie oder Platte kann beispielsweise eine dekorative Farbgestaltung, beispielsweise einen Farbverlauf, aufweisen. Der Farbeindruck wird beispielsweise durch Absorption und/oder Reflexion und/oder Transmission erzeugt.

Aufgrund von Reflexions- und/oder Transmissionsphänomenen kann es zu Interferenzerscheinungen, beispielsweise konstruktiver Interferenz und/oder destruktiver Interferenz, kommen, wodurch bei einem Betrachter Farbeindrücke erzeugt werden. Die Farbeindrücke können sich auch in Abhängigkeit vom Betrachtungswinkel ändern. Gemäß dem erfindungsgemäßen Verfahren werden vorzugsweise Dünnschichten aufgebracht, wobei es an jeder Dünnschicht zu Reflexions- und/oder Transmissionsphänomenen kommen kann. Durch Anordnen von zwei, drei, vier oder mehreren dünnen Schichten mi jeweils definierter Schichtdicke und definiertem Beschichtungsmaterial können definierte Farbeindrücke bei einem Betrachter erzeugt werden.

Die durch das erfindungsgemäße Verfahren hergestellte Folie oder Platte kann beispielsweise über eine Haftschicht auf einen beliebigen Gegenstand aufgebracht werden. Bei dem Gegenstand kann es sich beispielsweise um einen optisch transparenten Gegenstand aus Kunststoff und/oder Glas handeln. Bei dem Gegenstand kann es sich beispielsweise um einen Formkörper, beispielsweise ein Verkleidungsteil aus Kunststoff, vorzugsweise ein Kraftfahrzeugverkleidungsteil aus Kunststoff, handeln. Der Formkörper kann auch eine Kunststoffplatte oder Kunststoffscheibe oder Kunststofffolie sein.

Gemäß einer bevorzugten Variante der Erfindung ist die erfindungsgemäß zu beschichtende Folie, vorzugsweise zu beschichtende Kunststofffolie, oder die erfindungsgemäß zu beschichtende Platte, vorzugsweise zu beschichtende Kunststoffplatte, eine warmverformte, vorzugsweise tiefgezogene (Kunststoff-)Folie bzw. warmverformte, vorzugsweise tiefgezogene, (Kunststoff-)Platte.

Selbstverständlich kann die über das erfindungsgemäße Verfahren hergestellte Folie oder Platte auch auf einen Gegenstand aus Glas aufgebracht werden. Bei dem Gegenstand aus Glas kann es sich beispielsweise um eine Glasscheibe, Glasplatte, etc. handeln. Bei der Metallplatte kann es sich auch um ein Metallblech handeln.

Die Folie oder Platte kann dabei mit einem Haftmittel versehen werden oder eine Haftschicht aufweisen. Die Haftschicht kann beispielsweise eine thermisch und/oder chemisch aktivierbare Haftschicht sein.

Gemäß einer weiteren Variante der Erfindung kann die erfindungsgemäß beschichtete Folie, vorzugsweise Kunststofffolie, oder die erfindungsgemäß beschichtete Platte, vorzugsweise Kunststoffplatte, wobei die (Kunststoff-)Folie bzw. (Kunststoff-)Platte jeweils vor oder nach der Beschichtung mittels Dampfphasenabscheidung warmverformt, vorzugsweise tiefgezogen, sein kann, hinterspritzt oder umspritzt sein bzw. werden.

Mithin kann die erfindungsgemäß beschichtete Folie, vorzugsweise Kunststofffolie, oder die erfindungsgemäß beschichtete Platte, vorzugsweise Kunststoffplatte, wobei die (Kunststoff-)Folie bzw. (Kunststoff-)Platte jeweils vor oder nach der Beschichtung mittels Dampfphasenabscheidung warmverformt, vorzugsweise tiefgezogen, sein kann, in einem umspritzten Material, beispielsweise Kunststoff, eingebettet sein.

Bei einem Hinterspritzen mit einem Material, beispielsweise Kunststoff, bildet die erfindungsgemäß beschichtete Folie, vorzugsweise Kunststofffolie, oder die erfindungsgemäß beschichtete Platte, vorzugsweise Kunststoffplatte, wobei die (Kunststoff-)Folie bzw. (Kunststoff-)Platte jeweils vor oder nach der Beschichtung mittels Dampfphasenabscheidung warmverformt, vorzugsweise tiefgezogen sein kann, eine Außenoberfläche auf dem hinterspritzten Material aus.

Die wenigstens eine zu beschichtende Oberfläche kann beispielsweise grundiert werden oder sein. Die Aufbringung wenigstens einer Grundierungsschicht kann beispielsweise Unebenheiten, wie sie beim Druckguss erzeugt werden können, ausgleichen.

Auch kann nach Aufbringung der Schichten mittels Dampfphasenabscheidung wenigstens eine Lackschicht, beispielsweise wenigstens eine Schutzlackschicht, aufgebracht werden. Die wenigstens eine Schutzlackschicht kann dabei als Nanoversiegelung ausgebildet sein.

Gemäß einer Ausgestaltung des erfindungsgemäßen Verfahrens wird auf das wenigstens eine abgeschiedene Beschichtungsmaterial wenigstens eine Lackschicht, vorzugsweise wenigstens eine Schutzlackschicht, aufgebracht.

Gemäß einer weiteren Ausgestaltung des erfindungsgemäßen Verfahrens wird auf die wenigstens eine Oberfläche vor der Dampfabscheidung wenigstens eine Grundierungsschicht aufgebracht.

Selbstverständlich kann sowohl eine Grundierungsschicht als auch eine Lackschicht, vorzugsweise außenliegende, Schutzlackschicht aufgebracht werden.

Die wenigstens Grundierungsschicht und/oder die wenigstens eine Lackschicht können dabei in Form eines UV-Lacks oder als 2K-Lacks (2-Komponentenlack) aufgebracht werden.

Eine warmverformbare Folie weist im Sinne der vorliegenden Erfindung eine Schichtdicke von etwa 0,1 mm bis weniger als 1,5 mm, vorzugsweise 0,2 mm bis 1 mm auf. Eine Platte weist im Sinne der Erfindung eine Dicke größer als 1,5 mm auf. Die Dicke kann dabei in einem Bereich von 1,6 mm bis 25 mm, weiter vorzugsweise von 1,8mnm bis 15 mm, weiter bevorzugt von 2 mm bis 8 mm, liegen.

Sowohl die gemäß dem erfindungsgemäßen Verfahren mittels Dampfphasenabscheidung beschichtete Folie oder Platte können in einem weiteren Schritt optional dreidimensional verformt, vorzugsweise warmverformt, werden und weiter vorzugsweise mit Kunststoff und/oder Keramik und/oder Glas hinterspritzt werden.

Auf diese Weise ist es möglich, Formkörper mit definierten Abmessungen, beispielsweise zur Verwendung als Gehäuse oder im Kraftfahrzeugbau bereitzustellen.

Die bei dem erfindungsgemäßen Verfahren verwendbaren Folien oder Platten können aus thermoplastischen Kunststoffen hergestellt sein.

Als Thermoplasten können beispielsweise Acrylnitril-Butadien-Styrol (ABS), Polyamide (PA), Polylactat (PLA), Polymethylmethacrylat (PMMA), Polycarbonat (PC), Polyethylenterephthalat (PET), Polyetherimid (PEI), Polyethylen (PE), Polypropylen (PP), Polystyrol (PS), Polyetheretherketon (PEEK) oder Polyvinylchlorid (PVC) oder Mischungen oder Kombinationen davon verwendet werden. Polyolefine, beispielsweise Polyethylen oder Polypropylen, haben sich als sehr geeignete thermoplastische Materialien erwiesen.

Gemäß einer weiteren bevorzugten Variante der Erfindung wird der Thermoplast aus der Gruppe, die aus Polymethylmethacrylat (PMMA), Polycarbonat (PC), Polyethylenterephthalat (PET), Polyethylen (PE), Polypropylen (PP), Polyvinylchlorid (PVC), und Mischungen, und Kombinationen davon besteht, ausgewählt.

Gemäß einer weiteren bevorzugten Variante der Erfindung wird der Thermoplast aus der Gruppe, die aus Polymethylmethacrylat (PMMA), Polycarbonat (PC), Polyethylenterephthalat (PET), Polyvinylchlorid (PVC), und Mischungen, und Kombinationen davon besteht, ausgewählt.

Gemäß einer weiteren bevorzugten Variante der Erfindung wird der Thermoplast aus der Gruppe, die aus Polymethylmethacrylat (PMMA), Polycarbonat (PC), Polyethylenterephthalat (PET), und Mischungen, und Kombinationen davon besteht, ausgewählt.

Gemäß einer weiteren bevorzugten Variante der Erfindung wird der Thermoplast aus der Gruppe, die aus Polycarbonat (PC), Polyethylenterephthalat (PET), und Mischungen, und Kombinationen davon besteht, ausgewählt.

Bei einer weiteren Ausführungsform des erfindungsgemäßen Verfahrens kann die Dampfphasenabscheidung in Gegenwart eines reaktiven Gases, das vorzugsweise aus der Gruppe, die aus Luft, Sauerstoff, Stickstoff, kohlestoffhaltiger flüchtiger Verbindung, und Gemischen davon besteht, ausgewählt wird, durchgeführt werden.

Bei einer weiteren Variante des erfindungsgemäßen Verfahrens wird das während der Dampfphasenabscheidung abgeschiedene Beschichtungsmaterial aus der Gruppe, die aus Metall, Metalloxid, Metallcarbid, Metallnitrid, Metalloxycarbid, Metalloxynitrid, Metallcarbonitrid, Halbleitern, diamantähnlichem Kohlenstoff, und Mischungen davon besteht, ausgewählt.

Erfindungsgemäß ist es bevorzugt, dass das Metall aus der Gruppe, die aus Titan, Zirkonium, Vanadium, Niob, Chrom, Molybdän, Wolfram, Mangan, Eisen, Ruthenium, Osmium, Kobalt, Rhodium, Iridium, Nickel, Aluminium, Palladium, Platin, Kupfer, Silber, Gold, Mischungen und Legierungen davon, ausgewählt wird.

Vorzugsweise wird das Metall aus der Gruppe, die aus Chrom, Zirkonium, Aluminium, Kupfer, Silber, Gold, Gemischen davon, und Legierungen davon besteht, ausgewählt. Vorzugsweise wird das Metall aus der Gruppe, die aus Chrom, Aluminium, Zirkonium, Mischungen und Legierungen davon besteht, ausgewählt. Gemäß einer bevorzugten Variante der Erfindung wird als Metall Chrom verwendet.

Erfindungsgemäß ist es weiterhin bevorzugt, dass die Halbleiter aus der Gruppe, die aus Germanium, Silicium, Zinn, Kohlenstoff und Mischungen und Legierungen davon besteht, ausgewählt wird. Gemäß einer bevorzugten Ausführungsform wird als Halbleitermaterial Silicium verwendet.

Gemäß einer weiteren Variante kann Kohlenstoff in der Form als diamantähnlicher Kohlenstoff (DLC: Diamond-like Carbon) mittels Dampfphasenabscheidung abgeschieden werden.

Sofern die Dampfphasenabscheidung in Gegenwart eines reaktiven Gases erfolgt, beispielsweise bei reaktivem Sputtern, bei dem vorzugsweise neben einem inerten Arbeitsgas, wie beispielsweise Argon, ein oder mehrere reaktive Gase, beispielsweise Sauerstoff, Stickstoff und/oder kohlenstoffhaltige flüchtige Verbindung, zugesetzt werden, wird entsprechend Metalloxid, Metallcarbid, Metallnitrid, Metalloxycarbid, Metalloxynitrid oder Metallcarbonitrid abgeschieden.

Bei der flüchtigen kohlenstoffhaltigen Verbindung kann es sich beispielsweise um Methan, Ethan, Acetylen, und/oder Propan handeln, vorzugsweise Acetylen und/oder Propan.

Neben Sauerstoff oder Stickstoff können beispielsweise auch Wasserdampf, Ammoniak, Schwefelwasserstoff oder Tetrafluormethan als Reaktionsgas eingesetzt werden. Bei der Verwendung von Schwefelwasserstoff kann beispielsweise Metallsulfid abgeschieden werden.

Als sehr bevorzugt hat sich die Abscheidung von Metalloxiden und/oder Metallnitriden, vorzugsweise von Metallnitriden, erwiesen.

Beispielsweise kann bei Verwendung von Silicium als Verdampfungsmaterial in Gegenwart von Sauerstoff oder Wasser als reaktives Gas SiO₂ abgeschieden werden.

Gemäß einer weiteren erfindungsgemäßen Ausgestaltung des Verfahrens werden der wenigstens eine erste Teilbereich und der wenigstens eine zweite Teilbereich während der Dampfphasenabscheidung so abgeschieden, dass sie voneinander verschiedene optische Eigenschaften im Hinblick auf die Reflexion und/oder Transmission von sichtbarem Licht aufweisen.

Gemäß einer weiteren Ausgestaltung des erfindungsgemäßen Verfahrens werden der wenigstens eine erste Teilbereich und der wenigstens eine zweite Teilbereich während der Dampfphasenabscheidung so abgeschieden, dass sie voneinander verschiedene optische Eigenschaften im Hinblick auf Absorption und/oder Reflexion und/oder Transmission von Infrarotlicht aufweisen.

Mithin erlaubt das erfindungsgemäßer Verfahren die Bereitstellung von dekorativen Folien, Platten und/oder Gegenständen, die wenigstens zwei Teilbereiche, vorzugsweise drei, vier, oder mehr Teilbereiche, aufweisen, die sich im Hinblick auf die durch Absorption, Reflexion und/oder Transmission von sichtbarem Licht unterschiedliche optische Eigenschaften aufweisen.

Gemäß einer weiteren Variante des erfindungsgemäßen Verfahrens werden Folien, Platten oder Gegenstände bereitgestellt, die wenigstens zwei Teilbereiche, vorzugsweise drei, vier, fünf oder mehr Teilbereiche, aufweisen, die sich im Hinblick auf die Absorption, Reflexion und/oder Transmission von Infrarotlicht unterscheiden.

Mit sichtbarem Licht wird ein Wellenlängenbereich von etwa 400 nm bis weniger als 780 nm bezeichnet.

Bei Infrarotlicht handelt es sich vorzugsweise um nahes Infrarot in einem Wellenlängenbereich von vorzugsweise 780 nm bis 3 µm, weiter vorzugsweise von 800 nm bis 1,5 µm, weiter vorzugsweise von 850 nm bis 1 µm. Als sehr geeignet hat sich eine Wellenlänge von 890 bis 920 nm, beispielsweise von 905 nm, erwiesen.

Für das erfindungsgemäße Verfahren können vorzugsweise warmverformbare Folien oder Platten mit definierter Schichtenabfolge und/oder Schichtdicke hergestellt werden, die beispielsweise nach Warmverformung und optionaler Hinterspritzung als Formkörper, beispielsweise Gehäuse oder Verkleidungsteil, beispielsweise Kraftfahrzeugverkleidungsteil, verwendbar sind.

Gemäß einer Variante der Erfindung wird die Oberfläche vor der Beschichtung mittels Dampfphasenabscheidung, beispielsweise eine unbeschichtete Folie, vorzugsweise unbeschichtete Kunststofffolie, oder eine unbeschichtete Platte, vorzugsweise unbeschichtete Kunststoffplatte, warmverformt, beispielsweise mittels Tiefziehen.

Gemäß einer weiteren Variante der Erfindung wird die Oberfläche nach der Beschichtung mittels Dampfphasenabscheidung, beispielsweise eine erfindungsgemäß beschichtete Folie, vorzugsweise erfindungsgemäß beschichtete Kunststofffolie, oder eine erfindungsgemäß beschichtete Platte, vorzugsweise erfindungsgemäß beschichtete Kunststoffplatte, warmverformt, beispielsweise mittels Tiefziehen.

Ein solcher Formkörper, beispielsweise Gehäuse oder Verkleidungsteil, insbesondere Kraftfahrzeugverkleidungsteil, kann zur Abdeckung eines Lasers oder Radars (Radar: Radio Detection and Ranging), insbesondere einer lasergestützten oder radargestützten Abstandsmessung, verwendet werden. Beispielsweise wird als lasergestützte Abstandsmessung Lidar (Lidar: Light Detection and Ranging) oder Ladar (Ladar: Laser Detection and Ranging), beispielsweise bei der automatischen Abstandsmessung von Kraftfahrzeugen, insbesondere bei selbstfahrenden Kraftfahrzeugen, verwendet. Die Radarwellenlängen liegen im Millimeter bis Zentimeterbereich, vorzugsweise von 1 mm bis 100 mm, weiter vorzugsweise von 2 mm bis 10 mm.

Das zur Abstandsmessung verwendete Radar oder der zur Abstandmessung verwendete Laser, der vorzugsweise ein Infrarotlaser ist, wird beispielsweise in die Kraftfahrzeugkarosserie eingebaut. Um den äußeren optischen Eindruck eines Kraftfahrzeuges für einen Betrachter nicht zu beeinträchtigen, soll die Vorrichtung zur radargestützten oder lasergestützten Abstandsmessung von außen vorzugsweise für einen Betrachter nicht erkennbar sein.

Über das erfindungsgemäße Verfahren kann ein Formteil, beispielsweise ein Gehäuse oder Verkleidungsteil, insbesondere Kraftfahrzeugverkleidungsteil, hergestellt werden, das im Hinblick auf die im sichtbaren Licht für einen Betrachter erkennbaren dekorativen Eigenschaften, insbesondere im Hinblick auf die Absorption und/oder Reflexion und/oder Transmission von sichtbarem Licht in die Erscheinungsform der Kraftfahrzeugkarosserie so integriert ist, dass ein Betrachter die Vorrichtung für die radargestützte oder lasergestützte Abstandsmessung nicht erkennt. Im Hinblick auf die funktionalen optischen Eigenschaften, beispielsweise in Bezug auf Infrarotlicht, das zur Messung der Abstandsmessung verwendet werden kann, kann das Formteil, beispielsweise Gehäuse oder Verkleidungsteil entsprechend für Infrarotlicht durchlässig sein, um eine wirksame lasergestützte Abstandmessung durchzuführen.

Das durch das erfindungsgemäße Verfahren hergestellte Bauteil, beispielsweise Gehäuse oder Verkleidungsteil, insbesondere Kraftfahrzeugverkleidungsteil, kann beispielsweise in oder hinter den Kühlergrill, Stoßstange, etc. integriert sein.

Selbstverständlich kann das über das erfindungsgemäße Verfahren hergestellte Verkleidungsteil nicht nur im Kraftfahrzeugbereich verwendet werden. Die Laser- und Radarentfernungsmesser sind beispielsweise im Vermessungswesen allgemein verwendbar.

Mithin erlaubt das erfindungsgemäße Verfahren die Bereitstellung eines Formteils, beispielsweise von Gehäusen, die Teilbereiche aufweisen, in denen die dekorativen und/oder funktionalen optischen Eigenschaften im Hinblick auf sichtbares Licht und/oder im Hinblick auf Infrarotlicht separat und verschieden voneinander eingestellt werden können.

Die vorliegende Erfindung im Folgenden anhand von Beispielen und Figuren erläutert, ohne jedoch darauf beschränkt zu sein. Gleiche Elemente sind in den Figuren mit den gleichen Bezugszeichen versehen. Um Wiederholungen zu vermeiden sind die Bezugszeichen für gleiche Elemente in den verschiedenen Figuren teilweise nicht wiederholt mit Bezugszeichen versehen.

### Figuren

Fig. 1 zeigt eine über das erfindungsgemäße Verfahren hergestellte beschichtete Oberfläche, die einen ersten Teilbereich und einen zweiten Teilbereich aufweist, wobei die Schichtdicke des ersten Teilbereiches geringer ist als die Schichtdicke des zweiten Teilbereiches.
Fig. 2 zeigt die in Fig. 1 beschriebene Oberflächenbeschichtung mit zwei Teilbereichen (linke Darstellung), wenn diese Oberflächenbeschichtung für einen Betrachter vor einem dunklen Hintergrund (rechte Darstellung) angeordnet ist.
Fig. 3 zeigt eine Vorrichtung für die Dampfphasenabscheidung aus dem Stand der Technik.
Fig. 4 zeigt eine Vorrichtung für die Dampfphasenabscheidung aus dem Stand der Technik.
Fig. 5 zeigt eine beispielhafte Vorrichtung zur Durchführung des erfindungsgemäßen Verfahrens.
Fig. 6 zeigt eine beispielhafte Vorrichtung zur Durchführung des erfindungsgemäßen Verfahrens.
Fig. 7 zeigt eine beispielhafte Vorrichtung zur Durchführung des erfindungsgemäßen Verfahrens.
Fig. 8 zeigt eine beispielhafte Vorrichtung zur Durchführung des erfindungsgemäßen Verfahrens.
Fig. 9a zeigt eine beispielhafte Vorrichtung zur Durchführung des erfindungsgemäßen Verfahrens.
Fig. 9b zeigt eine beispielhafte Vorrichtung zur Durchführung des erfindungsgemäßen Verfahrens.

### Detaillierte Beschreibung der Figuren

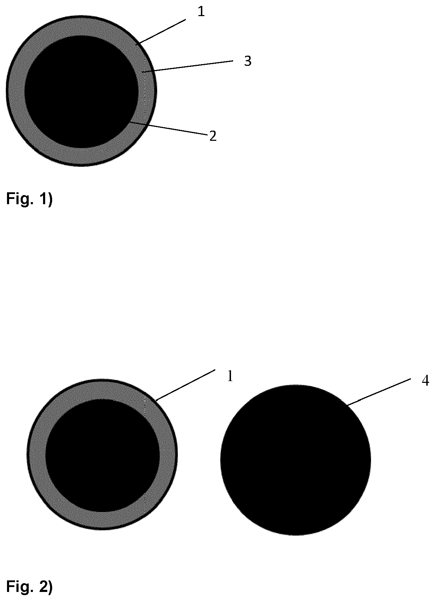

In Fig. 1 ist eine kreisrunde PVD-Oberflächenbeschichtung 1 mit einem zentralen Teilbereich 2 und einem peripheren Teilbereich 3 dargestellt. Der zentrale Teilbereich 2 ist eine homogene Beschichtung, der die Schichtdicke SD1 aufweist. Der periphere Teilbereich 3 weist eine homogene Beschichtung mit einer Schichtdicke SD2 auf. Die Schichtdicke SD1 ist dabei größer als die Schichtdicke SD2. Die beiden Teilbereiche 2 und 3 unterscheiden sich in dekorativer Hinsicht und können sich auch im Hinblick auf funktionale optische Eigenschaften, wie die Transmission bestimmter Wellenlängen, beispielsweise im nahen Infrarotbereich unterscheiden. So kann beispielsweise der Teilbereich 3 für nahes Infrarotlicht durchlässig sein.

In Fig. 2 ist die PVD-Oberflächenbeschichtung 1 als solche und vor einem dunklen Hintergrund 4 wiedergegeben. Der periphere Teilbereich 3 ist für einen Betrachter vor einem dunklen Hintergrund 4 nicht erkennbar. Für einen Betrachter sind mithin die beiden Teilbereiche 2 und 3 vor einem dunklen Hintergrund mit dem Auge nicht zu unterscheiden. Bei Anordnung der PVD-Beschichtung 1 vor einem dunklen Hintergrund kann ein Radar oder Laser einer Abstandsmessungsvorrichtung sowie ein Empfänger für reflektierendes Licht hinter der PVD-Beschichtung angeordnet sein, ohne dass dies von außen für einen Betrachter mit dem Auge erkennbar ist. Das Aussenden und Empfangen von Radarwellen (Radar) bzw. das Aussenden und Empfangen von IR-Strahlung (Lidar) kann über den Teilbereich 3 erfolgen.

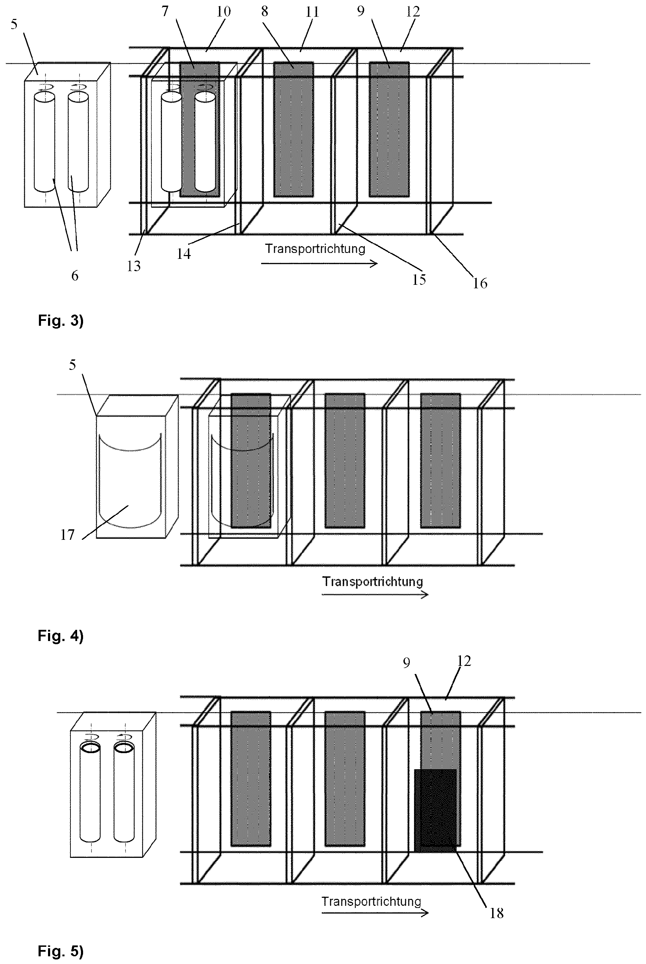

Fig. 3 zeigt eine schematische Darstellung einer Vorrichtung zur Durchführung eines Verfahrens zum Beschichten einer Oberfläche mittels Dampfphasenabscheidung in einem PVD-Verfahren aus dem Stand der Technik. Auf einem Transportwagen 5, der vor der ersten Beschichtungskammer dargestellt ist, sind zwei gegensinnig rotierende Spindeln 6 angeordnet. Jede Spindel 6 ist mit einem Drehzylinder versehen. An den Drehzylindern kann beispielsweise eine Folie angeordnet werden. Es kann auch ein dreidimensionaler Gegenstand an den Spindeln 6 angeordnet werden (nicht gezeigt). Der Transportwagen 5 ist sodann in eine Beschichtungsvorrichtung mit mehreren Beschichtungskammern 10, 11, 12 verfahrbar. Die Beschichtungskammern sind durch Schieber 13, 14, 15 und 16 voneinander getrennt. Ein weiterer Transportwagen mit zwei gegensinnig rotierenden Drehzylindern ist sodann in der ersten Beschichtungskammer 10 vor der ersten Kathode 7 dargestellt. Die Kathode 7 stellt die Verdampfungsquelle zum Verdampfen von Verdampfungsmaterial, das auch als Targetmaterial bezeichnet wird, bereit. Die lonenquelle zum Beschuss der Kathode ist in der schematischen Vorrichtung der Beschichtungskammern 10, 11, 12 jeweils nicht dargestellt. In der ersten Beschichtungskammer 10 drehen sich die Drehzylinder gegensinnig und vorzugsweise synchron. Das aus der Kathode 7 (Verdampfungsquelle) herausgelöste, verdampfte Material scheidet sich sodann auf der Oberfläche der auf den zwei gegensinnig rotierenden Drehzylindern angeordneten Oberfläche homogen ab. Die Kathode 7 einerseits und die zwei gegensinnig rotierenden Drehzylinder andererseits sind einander zugewandt angeordnet.

Das Beschichtungsverfahren mittels Dampfphasenabscheidung wird in der ersten Beschichtungskammer für einen ausreichenden Zeitraum durchgeführt, bis auf der auf den gegensinnig rotierenden Drehzylindern jeweils angeordneten Oberfläche eine Beschichtung mit gewünschter Schichtdicke abgeschieden ist. Nachfolgend kann der Schieber 14 geöffnet werden, so dass der in der ersten Beschichtungskammer 10 vorhandene Transportwagen in die zweite Beschichtungskammer 11 transportiert wird. Nachfolgend wird der Schieber 14 wieder geschlossen, so dass die erste Beschichtungskammer 10 und die zweite Beschichtungskammer 11 wieder voneinander getrennt sind. Der Schieber 15 zur dritten Beschichtungskammer 12 ist dabei geschlossen oder wieder verschlossen. In die erste Beschichtungskammer 10 kann, nachdem der Schieber 13 geöffnet ist, ein weiterer Transportwagen eingefahren werden. Nachdem Einfahren des Transportwagens in die erste Beschichtungskammer kann diese mit dem Schieber 13 wieder verschlossen werden. Der Pfeil gibt die Transportrichtung an.

In der zweiten Beschichtungskammer 11 kann sich das Verdampfungsmaterial der Kathode 8 von dem in der ersten Beschichtungskammer 10 vorhandenen Kathodenmaterial 7 unterscheiden. Ebenfalls kann sich in der dritten Beschichtungskammer 12 das Kathodenmaterial 9 von dem Kathodenmaterial 7 und optional von dem Kathodenmaterial 8 unterscheiden. Die in Fig. 3 dargestellte Vorrichtung erlaubt ein getaktetes Verfahren, bei dem in Intervallen sukzessive in den Beschichtungskammern 10, 11 und 12 jeweils eine Beschichtung auf die zu beschichtende Oberfläche in einer gewünschten Schichtdicke aufgebracht werden kann.

In der ersten Beschichtungskammer 10, der zweiten Beschichtungsammer 11, der dritten Beschichtungskammer 12 sind jeweils die erste Kathode 7, die zweite Kathode 8, sowie die dritte Kathode 9 in der jeweiligen Beschichtungskammer parallel zur Erstreckung der rotierenden Drehzylinder beabstandet angeordnet, so dass die jeweils auf den Drehzylindern angeordnete Oberfläche, beispielsweise eine Folie, bei Abscheidung des verdampften Materials homogen beschichtet wird.

In Fig. 4 ist eine Fig. 3 entsprechende Vorrichtung gezeigt, wobei jedoch im Unterschied zu Fig. 3 keine rotierenden Spindeln 6 bzw. Drehzylinder auf dem Transportwagen angeordnet sind. Vielmehr ist auf dem Transportwagen 5 ein gewölbtes Kunststoffteil 17 ortsfest angeordnet. Dieses gewölbte Kunststoffteil wird, wie in Fig. 3 beschrieben, analog durch Öffnung des Schiebers 13 in die erste Beschichtungskammer 10 verfahren. In der ersten Beschichtungskammer 10 wird sodann das gewölbte Kunststoffteil durch Beschuss (nicht gezeigt) der ersten Kathode 7 mittels Dampfphasenabscheidung beschichtet. Sobald in der ersten Beschichtungskammer eine Beschichtung mit gewünschter Schichtdicke abgeschieden ist, kann der Schieber 14 geöffnet und der Transportwagen 5 in die zweite Beschichtungskammer 11 verfahren werden. In der zweiten Beschichtungskammer 11 bzw. in der dritten Beschichtungskammer 12 können sodann weitere Beschichtungen mit den jeweils in der zweiten Kathode 8 bzw. dritten Kathode 9 enthaltenen Verdampfungsmaterial beschichtet werden.

Das jeweils mit den Vorrichtungen gemäß Fig. 3 und Fig. 4 durchgeführte Verfahren ist kein erfindungsgemäßes Verfahren.

Fig. 5 ist eine Vorrichtung zur Durchführung des erfindungsgemäßen Verfahrens und wird so gezeigt.

Die schematische Darstellung in Fig. 5 entspricht der Darstellung in Fig. 3 mit dem Unterschied, dass in der dritten Beschichtungskammer 12 eine Abschirmvorrichtung in Form einer Blende 18 angeordnet ist, die einen Teilbereich der im Transportwagen 5 angeordneten gegensinnig rotierenden Drehzylinder gegenüber der dritten Kathode 9 abschirmt. In der ersten Beschichtungskammer 10 kann eine vollflächige Beschichtung der jeweils auf den gegensinnig rotierenden Drehzylindern angeordneten Folie erfolgen. Beispielsweise kann in der ersten Beschichtungskammer eine Beschichtung der auf den Drehzylindern angeordneten gesamten Folie mit dem ersten Kathodenmaterial der Kathode 7, beispielsweise Chrom, erfolgen. Nach der Abscheidung der ersten Beschichtung, beispielsweise einer Chromschicht, in der ersten Beschichtungskammer 10 wird der Schieber 14 geöffnet und der Transportwagen 5 dann mit den in der ersten Beschichtungskammer beschichteten Folien in die zweite Beschichtungskammer 11 verfahren. Nach Einstellung des Transportwagens 5 in der zweiten Beschichtungskammer 11 wird der Schieber 14 wieder geschlossen. In der zweiten Beschichtungskammer 11 kann die zweite Kathode 8 aus dem gleichen Material bestehen wie das der ersten Kathode in der ersten Beschichtungskammer 10. Zusätzlich kann in der Unterdruckatmosphäre der zweiten Beschichtungskammer 11 neben einem inerten Arbeitsgas, wie zum Beispiel Argon, ein reaktives Gas, beispielsweise Stickstoff, enthalten sein. Nach Herauslösen der Kathodenmaterials aus der Kathode 8, beispielsweise von Chrom, kommt es zur chemischen Umsetzung in der Gasphase und zur Abscheidung der zweiten Beschichtung, beispielsweise von nitridischem Chrom, auf der ersten Beschichtung, beispielweise einer Chromschicht. Nach Beendigung des zweiten Beschichtungsvorganges in der zweiten Beschichtungskammer 11 wird der Schieber 15 geöffnet, der Transportwagen 5 in die dritte Beschichtungskammer 12 verfahren und der Schieber 15 wieder geschlossen. In der dritten Beschichtungskammer 12 ist eine Abschirmvorrichtung 18 in Form einer Blende ortsfest angeordnet. Die Blende 18 führt zu einer Abschirmung eines ersten Teilbereiches, der auf dem Transportwagen 5 angeordneten Drehzylinder. Bei der dritten Kathode 9 in der dritten Beschichtungskammer 12 kann es sich beispielsweise um ein graphitartiges Verdampfungsmaterial handeln. Die Blende 18 ist im unteren Bereich zwischen der dritten Kathode 9 und den Drehzylindern angeordnet, so dass ausschließlich der nicht abgeschirmte Teilbereich der Oberfläche der auf den Drehzylindern jeweils angeordneten Folie beschichtet wird. Bei Verwendung eines graphitartigen Kathodenmaterials in der dritte Kathode 9 kommt es zu einer Abscheidung von diamantähnlichem Kohlenstoff DLC (DLC: Diamond-like Carbon) auf dem nicht abgeschirmten Teil der Oberfläche der auf den Drehzylindern jeweils angeordneten Folie.

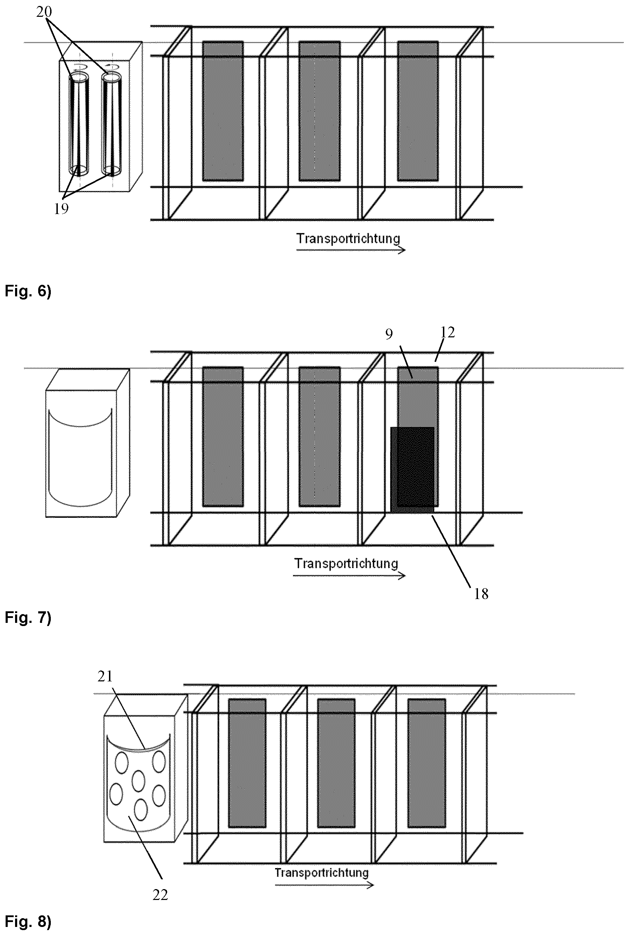

Fig. 6 zeigt eine Vorrichtung, die der Vorrichtung aus Fig. 3 entspricht, wobei jedoch zusätzlich mehrere Abschirmelemente 19 vorgesehen sind, die ortsfest angeordnet sind. Die Abschirmelemente 19 weisen in der in Fig. 6 dargestellten Ausführungsform jeweils eine dreieckige Geometrie auf. Die Abschirmelemente 19 sind dabei im Hinblick auf die Grundfläche der Dreiecke alternierend in gegenläufiger Anordnung an den und um die Drehzylinder herum angeordnet. Die Abschirmelemente 19 mit dreieckiger Geometrie sind dabei im Hinblick auf die gegensinnig rotierenden Drehzylinder ortsfest angeordnet. Im Hinblick auf die dreieckige Geometrie der Abschirmelemente 19 lässt sich mithin auf der jeweils auf den Spindeln 6 bzw. dem ummantelten Zylinder angeordneten Folie ein Beschichtungsmuster aus abgeschiedenem Beschichtungsmaterial erzeugen, das eine dreieckige Struktur, die jeweils dem dreieckigen Abschirmelement entspricht, aufweist. Abgesehen von der Anordnung der Abschirmelemente 19 mit dreieckiger Geometrie entspricht die in Fig. 6 dargestellte Vorrichtung der in Fig. 3 dargestellten Vorrichtung. Es wird insoweit auf die vorstehenden Ausführungen zu Fig. 3 entsprechend verwiesen.

Fig. 7 zeigt eine weitere Vorrichtung zur Durchführung des erfindungsgemäßen Verfahrens. Die Anordnung in Fig. 7 entspricht, abgesehen von dem Abschirmelement 18 in der dritten Beschichtungskammer 12, der Vorrichtung aus Fig. 5. Im Unterschied zu der in Fig. 5 dargestellten Vorrichtung sind auf dem Transportwagen keine rotierenden Spindeln 6 bzw. Drehzylinder angeordnet, sondern ein gewölbtes Kunststoffteil 17 ortsfest, wie es auch in Fig. 4 dargestellt ist. Im Unterschied zu der in Fig. 4 dargestellten Vorrichtung wird bei Verwendung der in Fig. 7 dargestellten Vorrichtung aufgrund des Abschirmelementes 18 nur der Teilbereich des gewölbten Kunststoffteils 17 in der dritten Beschichtungskammer 12 beschichtet, der nicht durch die Blende 18 abgeschirmt ist.

In Fig. 8 ist eine weitere Vorrichtung zur Durchführung des erfindungsgemäßen Verfahrens gezeigt. Die in Fig. 8 dargestellte Vorrichtung entspricht der in Fig. 4 dargestellten Vorrichtung, wobei im Unterschied zu der in Fig. 4 eingestellten Vorrichtung ein Abschirmelement 21 mit statistisch verteilt angeordneten kreisrunden Öffnungen, wobei die kreisrunden Öffnungen einen identischen Kreisdurchmesser aufweisen, vor dem gewölbten Kunststoffteil 22 angeordnet ist. Das gewölbte Kunststoffteil 22, das dem gewölbten Kunststoffteil 17 aus Fig. 4 entspricht, ist gegenüber den Kathoden 7, 8 und 9 in den Beschichtungskammern 10, 11 bzw. 12 bis auf die kreisförmigen Öffnungen in dem Abschirmelement 21, das auch als Lochblende bezeichnet werden kann, abgeschirmt. Das Abschirmelement 21 ist flächig über dem zu beschichtenden gewölbten Kunststoffteil 22 leicht beabstandet angeordnet. Mithin können in den Beschichtungskammern 10, 11 und 12 nur die nicht abgeschirmten kreisförmigen Teilbereiche des gewölbten Kunststoffteils, bei denen die von den Kathoden 7, 8 und 9 verdampften Materialien durch die kreisförmigen Öffnungen des Abschirmelementes 21 auf das gewölbte Kunststoffteil 22 gelangen können, beschichtet werden.

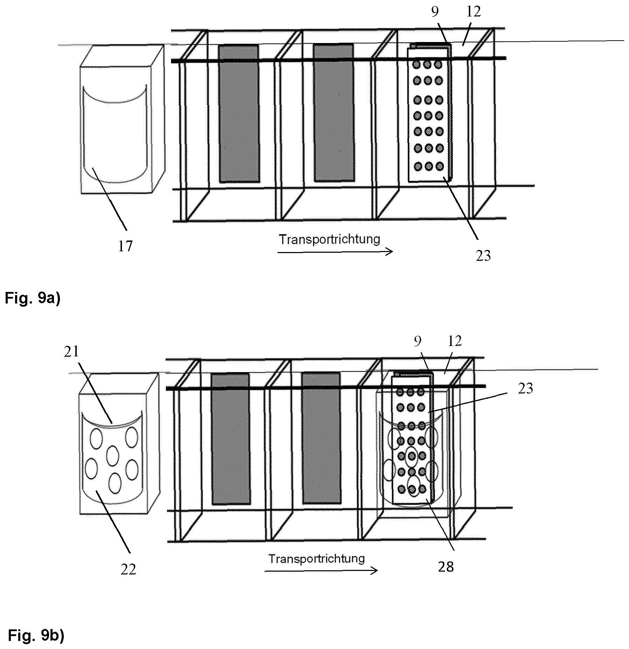

Fig. 9a zeigt eine weitere Vorrichtung zur Durchführung des erfindungsgemäßen Verfahrens. Die in Fig. 9a gezeigte Vorrichtung entspricht der in Fig. 4 dargestellten Vorrichtung mit dem Unterschied, dass vor der dritten Kathode 9 in der dritten Beschichtungskammer 12 ein Abschirmelement 23 mit kreisrunden Öffnungen, die symmetrisch und gleichmäßig über die Fläche des Abschirmelements angeordnet sind, ortsfest und die gesamte Kathode 9 abdeckend angeordnet ist. Im Unterschied zu der in Fig. 4 dargestellten Vorrichtung werden in der dritten Beschichtungskammer 12 der in Fig. 9a gezeigten Vorrichtung nur diejenigen Teilbereiche des gewölbten Kunststoffteils mit einer dritten Beschichtung versehen, die durch die Öffnungen in dem Abschirmelement 23 exponiert sind.

Fig. 9b stellt eine weitere Vorrichtung zur Durchführung des erfindungsgemäßen Verfahrens dar, das ein Kombination der Verfahren ist, die mit den Vorrichtungen in Fig. 9a und Fig. 8 durchgeführt werden. Mit der Vorrichtung in Fig. 9b werden die Blendenanordnungen aus Fig. 9a und Fig. 8 kombiniert, so dass komplexe Beschichtungsmuster auf der zu beschichtenden Oberfläche erzeugt werden können.

Das gewölbte Kunststoffteil 22 ist dabei auf dem Transportwagen 5 durch das Abschirmelement 21 mit Öffnungen teilweise abgeschirmt. In der dritten Beschichtungskammer 12 ist in Analogie zu der in Fig. 9a dargestellten Vorrichtung vor der dritten Kathode 9 ein weiteres Abschirmelement 23 mit Öffnungen vorgesehen. In der in Fig. 9b dargestellten Vorrichtung können somit Beschichtungen abgeschieden werden, bei denen es zu einer Überlagerung von Mustern kommt, die im Überlappungsbereich 28 durch das erste Abschirmelement 21 mit dessen Öffnungen und das zweite Abschirmelement 23 mit dessen Öffnungen erzeugt werden. Die Anordnung und/oder Größe und/oder Geometrie der Öffnungen können in den verschiedenen Abschirmelementen 21 und 23 unabhängig voneinander kombiniert werden. Selbstredend ist eine Kombination mit weiteren Abschirmelementen bei dem erfindungsgemäßen Verfahren möglich und im Schutzumfang der Patentansprüche enthalten.

Die in den Fig. 5, 6, 7, 8, 9a und 9b dargestellten Vorrichtungen erlauben die Durchführung des erfindungsgemäßen Verfahrens, wobei vollflächige Beschichtungen mit Beschichtungen, die lediglich in Teilbereichen abgeschieden werden, auf einer zu beschichtenden Oberfläche miteinander kombiniert werden können. Durch die Anordnung von wenigstens einem Abschirmelement oder einer Kombination von mehreren Abschirmelementen in einer, zwei, drei, vier oder mehr Beschichtungskammern lassen sich auf einfache Weise zuverlässig definiert inhomogene Beschichtungen erzeugen, die dekorativ ansprechende Inhomogenitäten aufweisen. Alternativ oder kumulativ könne durch definierte Inhomogenitäten funktionale optische Effekte auf einer zu beschichtenden Oberfläche erzeugt werden.

### Beispiele

### Beispiel 1

Auf einem auf einer rotierbaren Spindel angeordnetem Kunststoffzylinder mit einem Durchmesser von ca. 11 cm und einer Länge von ca. 50 cm wurde eine 0,5 mm dicke transparente Makrolonfolie der Bayer AG angeordnet. Die Kathode bestand aus Chrom und wies eine Größe von 23 cm x 77 cm auf. Die Vorrichtung entsprach dabei der in Fig. 5 dargestellten und der oben beschriebenen Vorrichtung.

Die Spindeln wurden mit einer Frequenz von 12 Umdrehungen/min durch einen Antriebsmotor gedreht. In der ersten Beschichtungskammer wurde als Verdampfungsmaterial Chrom verwendet. Der Arbeitsdruck in der Beschichtungskammer betrug ca. 1x10⁻³ mbar. Als Arbeitsgas wurde Argon verwendet. In der ersten Beschichtungskammer 10 wurde eine transluzente Chromschicht mit einer Schichtdicke von 35 nm innerhalb von 30 Sekunden aufgebracht.

In der zweiten Beschichtungskammer wurde zusätzlich zu Argon Stickstoff als Reaktivgas mit 70 sccm bei einem Druck von ca. 2,7x10⁻³ mbar in die Beschichtungskammer gegeben. Die Kathode bestand aus Chrom und wies die gleichen Abmessungen wie in der ersten Beschichtungskammer auf. Die nitridische Chromschicht wurde mit einer Schichtdicke von ca. 100 nm innerhalb von 120 Sekunden abgeschieden. Die nitridische Chromschicht wies dabei ein goldenbraunes Erscheinungsbild auf der ersten transluzenten Chromschicht auf.

In der dritten Beschichtungskammer wurde sodann eine diamantähnliche Kohlenstoffschicht (DLC-Schicht) mit einer Schichtdicke von ca. 10 nm innerhalb von 60 Sekunden aufgebracht. Als Kathodenmaterial wurde Graphit verwendet. Die Graphitkathode wies die gleichen Abmessungen wie die Chromkathode in der ersten bzw. zweiten Beschichtungskammer auf. Die untere Hälfte der Graphitkathode war mit einer metallischen Blende (30 cm Breite und 40 cm Höhe) abgeschirmt, so dass nur in der oberen Hälfte eine DLC-Schicht abgeschieden wurde. Als Arbeitsgas wurde Argon bei einem Druck von ca. 1,7x10⁻³ mbar verwendet.

Die obere Hälfte wies sodann einen homogen rotgefärbten Folienbereich auf. Sowohl die obere Hälfte der Folie als auch die untere Hälfte der Folie waren in sich homogen, obgleich die optischen Eigenschaften der Folie in der oberen Hälfte und der unteren Hälfte voneinander verschieden waren. Die obere und untere Hälfte der Folie waren dabei durch einen kleinen Farb-Übergangsbereich voneinander getrennt.

Weitere Beschichtungen wie Beispiel 1 vorstehend beschrieben, die analog in dieser Weise durchgeführt wurden haben gezeigt, dass durch Erhöhung der Schichtstärke in der zweiten Beschichtungskammer zur Erzeugung einer nitridischen Chromschicht folgende Basis-Farben von hellem Gold bis braun Gold über violett bis zu einem tiefen blau bis hin zu einem türkisen Farbton realisierbar waren. Bei Kombination dieser nitridischen Chromschichten mit einer sehr dünnen DLC-Schicht, wie vorstehend beschrieben, ließen sich entsprechende Farbwechsel erzeugen. So waren beispielsweise Farbwechsel von einem blauen zu einem grünen Farbton ohne weiteres realisierbar. Ebenfalls zeigte sich, dass durch eine sukzessive Erhöhung der DLC-Schicht Farbwechsel in nm-Sprüngen realisierbar waren. So konnten von dem im vorstehenden Beispiel 1 erzeugten rötlichen Farbton Farbwechsel zu violett oder zu einem tiefen Blau oder zu einem intensiven türkis erzeugt werden, in dem die Schichtstärke der DLC-Schicht in einem Intervall von jeweils ca. 4nm erhöht wurde.

Die erfindungsgemäß hergestellten Beschichtungen, die über die Zylinderform erzeugt wurden, eigneten sich hervorragend, um sich in einem Warmformverfahren in eine gewünschte 3D-Form zu überführen. Weiterhin hat sich gezeigt, dass sich derartige Beschichtungen mit etwaigen Nanoversiegelungen hervorragend versiegeln lassen.

### Beispiel 2

Das erfindungsgemäße Verfahren wurde mit der in Fig. 6 dargestellten Vorrichtung durchgeführt. In Entsprechung zu Beispiel 1 wurde eine 0,5 mm dicke Makrolonfolie der Firma Bayer auf dem Kunststoffzylinder mit einem Durchmesser von ca. 11 cm und einer Länge von ca. 50 cm angeordnet. Die Spindeln wurden mit einer Frequenz von 12 Umdrehungen/min durch einen Antriebsmotor gedreht. Der Arbeitsdruck in der Beschichtungskammer betrug 1x10⁻³ mbar. Als Arbeitsgas wurde Argon verwendet. Die Vorrichtung entsprach dabei der in Fig. 6 dargestellten und oben beschriebenen Vorrichtung.

In einem Abstand von ca. 2 cm vor dem mit der Makrolonfolie ummantelten Zylinder wurden Abschirmelemente mit dreieckiger Geometrie alternierend in gegenläufiger Ausrichtung der Dreiecke ca. 2 cm vor dem ummantelten Zylinder angeordnet. Die dreieckigen Abschirmelemente wiesen eine Basis von 3 cm und eine Höhe von 50 cm auf. Um den Umfang des Drehzylinders waren in einem Abstand von 2 cm oberhalb der Folienoberfläche um den Umfang herum symmetrisch gegenläufig dreieckige Abschirmelemente angeordnet. In der ersten Beschichtungskammer wurde die Folie, wie in Beispiel 1 beschrieben, mit einer Chromschicht beschichtet. Es wurden sodann keine weiteren Beschichtungen in der zweiten bzw. dritten Beschichtungskammer aufgebracht.

Die auf der Folie aufgebrachte Chrombeschichtung zeigte Muster von gegenläufigen Dreiecksformen, wobei die nicht durch die dreieckigen Abschirmelemente abgeschirmten Bereiche eine transluzente Chromschicht von ca. 35 nm aufwiesen. Die durch die Dreieckselemente abgeschirmten Bereiche wiesen eine signifikant verringerte Beschichtung an Chrom auf. Wie in Fig. 2 veranschaulicht zeigt sich vor einem dunklen Hintergrund ein für einen Betrachter homogener Chromspiegel. Bei Hinterlegung der Folien mit einem hellen Hintergrund sind die gegenläufigen Dreiecksformen abwechselnd als hell und dunkel sichtbar.

Insbesondere die hellen homogenen Beschichtungsbereiche eignen sich zu einer Verbesserung der Laser- oder Radartransparenz im Vergleich zu einer Chromschicht mit einer Schichtdicke von etwa 30 bis 35 nm.

### Beispiel 3

In Beispiel 3 wurde das erfindungsgemäße Verfahren unter Verwendung der in Fig. 9a beschriebenen Vorrichtung durchgeführt. Auf dem Transportwagen wurde eine gewölbte transparente Makrolonfolie, die eine Größe von 50cm x 50 cm aufwies, mit einer Schichtdicke mit 0,5 mm ortsfest angeordnet. Die Vorrichtung entsprach der in Beispiel 1 bzw. Beispiel 2 beschriebenen Vorrichtung. Im Gegensatz erfolgte hier aber keine Drehung am Bauteil.

In der ersten Beschichtungskammer und der zweiten Beschichtungskammer erfolgte keine Beschichtung. In der dritten Beschichtungskammer wurde vor einer Silicium-Kathode ein Abschirmelement 23 mit kreisförmigen Öffnungen, mithin eine Lochblende, im Abstand von ca. 9 cm vor der Silicium-Kathode angeordnet. Die Lochblende im Maßstab der Kathode wies über die gesamte Fläche symmetrisch verteilt kreisförmige Öffnungen mit einem Durchmesser von 2,5 cm auf. Die Lochblende deckte die dritte Kathode 9 mit einer Größe von ca. 23 cm Breite x ca. 77 cm Höhe vollständig ab. Die gewölbte Kunststofffolie wurde sodann für 20 Sekunden mit Silicium bedampft. Auf der so bedampften Folie wurde ein mit dem Auge nur sehr schwer erkennbares Streifenmuster mit alternierend angeordneten hellen homogenen und dunklen homogenen Streifen ausgebildet. Eine nachträgliche schwarze Konter-Lackierung lässt den erzeugten Film für einen äußeren Betrachter als völlig homogenen Spiegel erscheinen.

### Beispiel 4

In Beispiel 4 wurde die in Fig. 9b beschriebene Vorrichtung verwendet, wobei die Bedampfung ausschließlich in der dritten Beschichtungskammer 12 erfolgte. Beispiel 4 wurde wie Beispiel 3 durchgeführt, wobei vor der gewölbten transparenten Makrolonfolie zusätzlich ein gleichförmiges Abschirmelement 21 zur Makrolonfolie mit beliebigen Öffnungen angeordnet wurde. Das Abschirmelement hatte eine Größe von ca. 50 cm x 50 cm und wies beliebig verteilte kreisförmige Öffnungen mit einem Durchmesser von 10 cm auf. Der Abstand zwischen dem Abschirmelement 21 und der zu beschichtenden Folie betrug dabei 2 mm. In der ersten und zweiten Kammer erfolgte keine Beschichtung. In der dritten Kammer war, wie in Beispiel 3 eine Lochblende Abschirmelement 23 vor der Kathode angeordnet. Die Beschichtung erfolgte hierbei mit Silicium für 20 Sekunden.

Die in Beispiel 4 erhaltene Beschichtung entsprach der Beschichtung in Beispiel 3, das von einem zusätzlichen Muster überlagert wurde.

Die so beschichtete Folie zeigte ein Erscheinungsbild der beliebig angeordneten Kreise des vor der Makrolonfolie gleichförmig angebrachten Abschirmelements 21. Durch die definierten Inhomogenitäten in der Beschichtung eignet sich auch diese Folie zur Verwendung als Verblendung eines Radarsystems bzw. Lasersystems, insbesondere zur Abstandsmessung. Eine zusätzlich schwarze Konter-Lackierung der Beschichtung verleiht der Beschichtung ein dekoratives designerisches Element.

In Tabelle 1 sind die in den erfindungsgemäßen Beispielen 1 bis 4 verwendeten Anordnungen und die verwendeten Beschichtungsmaterialien zusammenfassend angegeben.

**Tabelle 1**

| **Erfindungsgemäßes Beispiel** | **Blenden-Anordnung** | **Beschichtungs Kammer 1 Target** | **Beschichtungs Kammer 2 Target** | **Beschichtungs Kammer 3 Target** |
|---|---|---|---|---|
| **1** | **Fig. 5** | Cr | Cr | Graphit |
| **2** | **Fig. 6** | Cr | | |
| **3** | **Fig. 9a** | | | Si |
| **4** | **Fig. 9b** | | | Si |

### Bezugszeichenliste:

- 1:: PVD-Oberflächen-Beschichtung
- 2:: Zentraler Teilbereich mit Schichtdicke SD1
- 3:: Peripherer Teilbereich mit Schichtdicke SD2
- 4:: Dunkler Hintergrund
- 5:: Transportwagen
- 6:: Spindeln
- 7:: Kathode 1
- 8:: Kathode 2
- 9:: Kathode 3
- 10:: Beschichtungskammer 1
- 11:: Beschichtungskammer 2
- 12:: Beschichtungskammer 3
- 13,: 14,15,16: Schieber
- 17:: Gewölbtes Kunststoffteil
- 18:: Blende
- 19:: Abschirmung
- 20:: Mit Folie ummantelter Zylinder
- 21:: Abschirmung mit kreisförmigen Aussparungen
- 22:: Gewölbtes Kunststoffteil
- 23:: Abschirmung mit kreisförmigen Aussparungen
- 28:: Überlappungsbereich

## Patentansprüche

1. Verfahren zum Beschichten wenigstens einer Oberfläche mittels Dampfphasenabscheidung in wenigstens einer Beschichtungskammer, die wenigstens eine Verdampferquelle zum Verdampfen von wenigstens einem Verdampfungsmaterial enthält,
**dadurch gekennzeichnet, dass**
wenigstens ein erstes Beschichtungsmaterial in wenigstens einem ersten Teilbereich der Oberfläche mit wenigstens einer ersten Schichtdicke und in wenigstens einem zweiten Teilbereich der Oberfläche mit wenigstens einer zweiten Schichtdicke, wobei die wenigstens eine erste und die wenigstens eine zweite Schichtdicke voneinander verschieden sind, mittels Dampfabscheidung abgeschieden wird,
oder
wenigstens in einem ersten Teilbereich der Oberfläche wenigstens ein erstes Beschichtungsmaterial und wenigstens in einem zweiten Teilbereich der Oberfläche wenigstens ein zweites Beschichtungsmaterial, das verschieden von dem wenigstens einen ersten Beschichtungsmaterial ist, mittels Dampfabscheidung abgeschieden wird,
wobei in wenigstens einer Beschichtungskammer zwischen wenigsten einer Verdampferquelle und wenigstens einem Teilbereich der Oberfläche wenigstens ein Abschirmelement zum Abschirmen dieses Teilbereichs während der Dampfphasenabscheidung vorgesehen wird.

2. Verfahren nach Anspruch 1,
**dadurch gekennzeichnet,**
**dass** die wenigstens eine Oberfläche und die wenigstens eine Verdampferquelle während der Dampfphasenabscheidung relativ zueinander bewegt werden.

3. Verfahren nach Anspruch 1 oder 2,
**dadurch gekennzeichnet,**
**dass** die wenigstens eine Oberfläche relativ zu der wenigstens einen Verdampferquelle während der Dampfphasenabscheidung rotiert oder bewegt, vorzugsweise rotiert, wird oder dass die wenigstens eine Oberfläche ortsfest zu der wenigstens einen Verdampferquelle während der Dampfphasenabscheidung angeordnet ist.

4. Verfahren nach Anspruch 2 oder 3,
**dadurch gekennzeichnet,**
**dass** die wenigstens eine Oberfläche während der Dampfphasenabscheidung an oder auf einem Drehelement, vorzugsweise einem Drehzylinder, angeordnet wird.

5. Verfahren nach einem der vorherigen Ansprüche,
**dadurch gekennzeichnet,**
**dass** das wenigstens eine Beschichtungsmaterial in wenigstens einem ersten Teilbereich der Oberfläche und in wenigsten einem zweiten Teilbereich der Oberfläche in einer gemeinsamen Schichtebene mit voneinander verschiedenen Schichtdicken mittels Dampfphasenabscheidung abgeschieden werden.

6. Verfahren nach einem der vorhergehenden Ansprüche,
**dadurch gekennzeichnet,**
**dass** das wenigstens eine Abschirmelement zwischen wenigsten einer Verdampferquelle und dem abgeschirmten Teilbereich in wenigstens einer Beschichtungskammer ortsfest oder beweglich, vorzugsweise ortsfest, angeordnet wird.

7. Verfahren nach einen der vorhergehenden Ansprüche,
**dadurch gekennzeichnet,**
**dass** das wenigstens eine Abschirmelement Öffnungen aufweist, wobei die Öffnungen in dem wenigstens einen Abschirmelement symmetrisch oder asymmetrisch verteilt angeordnet sein können.

8. Verfahren nach einem der vorherigen Ansprüche,
**dadurch gekennzeichnet,**
**dass** auf die wenigstens eine Oberfläche mittels Dampfphasenabscheidung mehrere übereinanderliegende Schichten abgeschieden werden, wobei wenigstens eine Schicht der mehreren Schichten wenigstens nur in einem Teilbereich der Oberfläche abgeschieden wird.

9. Verfahren nach einem der vorherigen Ansprüche,
**dadurch gekennzeichnet;**
**dass** die wenigstens eine Oberfläche unter Verwenden einer Transportvorrichtung durch mehrere Beschichtungskammern transportiert wird,
wobei in wenigstens einer Beschichtungskammer zwischen wenigstens einer Verdampferquelle und wenigstens einem Teilbereich wenigstens ein Abschirmelement zum Abschirmen dieses Teilbereichs während der Dampfphasenabscheidung vorgesehen wird und
wobei in der jeder weiteren Beschichtungskammer zwischen wenigstens einer Verdampferquelle und wenigstens einem Teilbereich wenigstens ein Abschirmelement zum Abschirmen dieses Teilbereichs während der Dampfphasenabscheidung vorgesehen sein können.

10. Verfahren nach einem der vorherigen Ansprüche,
**dadurch gekennzeichnet,**
**dass** die wenigstens eine Oberfläche die Oberfläche einer Folie und/oder Platte ist oder die wenigstens eine Oberfläche die Oberfläche eines dreidimensionalen Gegenstands, vorzugsweise aus oder mit Kunststoff, Keramik, Metall, und/oder Glas, ist.

11. Verfahren nach Anspruch 10,
**dadurch gekennzeichnet,**
**dass** die Folie und/oder Platte Kunststoff aufweist oder daraus besteht und in einem weiteren Schritt dreidimensional verformt, vorzugsweise warmverformt wird, und optional mit Kunststoff hinterspritzt wird.

12. Verfahren nach Anspruch 10,
**dadurch gekennzeichnet,**
**dass** die Folie oder Platte Metall aufweist oder daraus besteht und in einem weiteren Schritt dreidimensional verformt, vorzugsweise tiefgezogen, wird und optional mit Kunststoff, Keramik, und/oder Glas hinterspritzt wird.

13. Verfahren nach einem der vorherigen Ansprüche,
**dadurch gekennzeichnet,**
**dass** die Dampfphasenabscheidung in Gegenwart eines reaktiven Gases, das vorzugsweise aus der Gruppe, die aus Luft, Sauerstoff, Stickstoff, kohlenstoffhaltiger flüchtiger Verbindung, und Gemischen davon besteht, ausgewählt wird, durchgeführt wird.

14. Verfahren nach einem der vorherigen Ansprüche,
**dadurch gekennzeichnet,**
**dass** das während der Dampfphasenabscheidung abgeschiedene Beschichtungsmaterial aus der Gruppe, die aus Metall, Metalloxid, Metallcarbid, Metallnitrid, Metalloxycarbid, Metalloxynitrid, Metallcarbonitrid, Halbleitern, diamantähnlichem Kohlenstoff, und Mischungen davon besteht, ausgewählt wird.

15. Verfahren nach einem der vorherigen Ansprüche,
**dadurch gekennzeichnet,**
**dass** auf das wenigstens eine abgeschiedene Beschichtungsmaterial wenigstens eine Lackschicht, vorzugsweise wenigstens eine Schutzlackschicht, aufgebracht wird.

16. Verfahren nach einem der vorherigen Ansprüche,
**dadurch gekennzeichnet,**
**dass** auf die wenigstens eine Oberfläche vor der Dampfabscheidung wenigstens eine Grundierungsschicht aufgebracht wird.

17. Verfahren nach einem der vorherigen Ansprüche,
**dadurch gekennzeichnet,**
**dass** der wenigstens eine erste Teilbereich und der wenigstens eine zweite Teilbereich während der Dampfphasenabscheidung so abgeschieden werden, dass sie voneinander verschiedene optische Eigenschaften im Hinblick auf Absorption und/oder Reflexion und/oder Transmission von sichtbarem Licht aufweisen.

18. Verfahren nach einem der vorherigen Ansprüche,
**dadurch gekennzeichnet,**
**dass** der wenigstens eine erste Teilbereich und der wenigstens eine zweite Teilbereich während der Dampfphasenabscheidung so abgeschieden werden, dass sie voneinander verschiedene optische Eigenschaften im Hinblick auf Absorption und/oder Reflexion und/oder Transmission von Radarwellen und/oder Infrarotlicht aufweisen.

19. Beschichtete Oberfläche,
**dadurch gekennzeichnet,**
**dass** die beschichtete Oberfläche über ein Verfahren gemäß einem der vorstehenden Ansprüche erhältlich ist.

20. Verwendung einer beschichteten Oberfläche nach Anspruch 19 zu dekorativen Zwecken und/oder funktionalen optischen Zwecken.
